(19) Europäisches Patentamt
European Patent Office
Office européen des brevets

(11) EP 2 151 715 A1

(12) **EUROPEAN PATENT APPLICATION**
published in accordance with Art. 153(4) EPC

(43) Date of publication:
**10.02.2010 Bulletin 2010/06**

(21) Application number: **08752247.0**

(22) Date of filing: **30.04.2008**

(51) Int Cl.:
***G03F 7/027*** *(2006.01)* ***C08G 73/10*** *(2006.01)*
***C09J 4/02*** *(2006.01)* ***C09J 7/02*** *(2006.01)*
***C09J 163/00*** *(2006.01)* ***C09J 179/08*** *(2006.01)*
***G03F 7/004*** *(2006.01)* ***G03F 7/037*** *(2006.01)*
***H01L 21/027*** *(2006.01)*

(86) International application number:
**PCT/JP2008/058246**

(87) International publication number:
**WO 2008/149625 (11.12.2008 Gazette 2008/50)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **06.06.2007 JP 2007150298**
**30.10.2007 JP 2007282055**

(71) Applicant: **Hitachi Chemical Company, Ltd.**
**Tokyo 163-0449 (JP)**

(72) Inventors:
- **MITSUKURA, Kazuyuki**
**Tsukuba-shi**
**Ibaraki 300-4247 (JP)**
- **KAWAMORI, Takashi**
**Tsukuba-shi**
**Ibaraki 300-4247 (JP)**
- **MASUKO, Takashi**
**Tsukuba-shi**
**Ibaraki 300-4247 (JP)**
- **KATOGI, Shigeki**
**Tsukuba-shi**
**Ibaraki 300-4247 (JP)**

(74) Representative: **Jönsson, Hans-Peter**
**Patentanwälte von Kreisler Selting Werner**
**Deichmannhaus am Dom**
**Bahnhofsvorplatz 1**
**50667 Köln (DE)**

(54) **PHOTOSENSITIVE ADHESIVE COMPOSITION, FILM-LIKE ADHESIVE, ADHESIVE SHEET, METHOD FOR FORMING ADHESIVE PATTERN, SEMICONDUCTOR WAFER WITH ADHESIVE LAYER, SEMICONDUCTOR DEVICE AND METHOD FOR MANUFACTURING SEMICONDUCTOR DEVICE**

(57) A photosensitive adhesive composition comprising (A) an alkali-soluble polymer, (B) a thermosetting resin, (C) one or more radiation-polymerizable compounds and (D) a photoinitiator, wherein the 5% weight reduction temperature of the mixture of all of the radiation-polymerizable compounds in the composition is 200°C or higher.

*Fig.4*

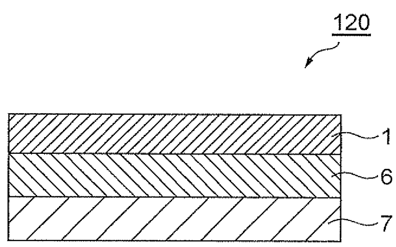


EP 2 151 715 A1

## Description

## Technical Field

The present invention relates to a photosensitive adhesive composition, a film-like adhesive, an adhesive sheet, a method for forming an adhesive pattern, a semiconductor wafer with an adhesive layer, a semiconductor device and a method for manufacturing a semiconductor device.

## Background Art

Various forms of semiconductor packages have been proposed in recent years to meet higher performance and function demands for electronic parts. The adhesives used to bond semiconductor elements with semiconductor element-mounting supporting members in semiconductor packages are often required to have, in addition to low-stress properties, low-temperature adhesion, moisture-proof reliability and solder reflow resistance, also a photosensitive function allowing pattern formation, depending on the method of simplifying the semiconductor package function, form and assembly process.

Photosensitivity is a function whereby sections irradiated with light are chemically altered to become insolubilized or solubilized in aqueous solutions or organic solvents. When a photosensitive adhesive exhibiting photosensitivity is used, it is exposed through a photomask and a pattern is formed with a developing solution, thus allowing a high definition adhesive pattern to be formed.

The materials with photosensitivity functions allowing such pattern formation have hitherto been photoresists and polyimide resin precursors (polyamide acids) or polyimide resin-based materials (see Patent documents 1-3, for example).

[Patent document 1] Japanese Unexamined Patent Publication No. 2000-290501
[Patent document 2] Japanese Unexamined Patent Publication No. 2001-329233
[Patent document 3] Japanese Unexamined Patent Publication HEI No. 11-24257

## Disclosure of the Invention

### Problems to be Solved by the Invention

However, the aforementioned materials with photosensitivity functions have not been designed with the idea of adhesive function in mind. Furthermore, when such materials are used as adhesives for the aforementioned semiconductor packages, it has been difficult to ensure heat resistance with materials such as photoresists.

With polyimide resin precursors (polyamide acids) and polyimide resins, such materials are superior in terms of heat resistance but require high temperatures of 300°C and above during thermal cyclization/imidation when using polyamide acids or during working when using polyimide resins, and therefore the thermal damage on surrounding materials is significant while thermal stress also tends to occur.

It has been attempted, incidentally, to improve low-temperature workability and soldering heat resistance by combining and crosslinking thermosetting resins with adhesives comprising polyimide resins and the like. However, it has been difficult with such methods to simultaneously achieve high levels of both the pattern formability with alkali developing solutions and the low-temperature attachment property onto adherends. Also, with the conventional materials it has been difficult to impart a satisfactory re-adhesion property that allows sufficiently high adhesive force to be exhibited upon thermocompression bonding after light exposure, while it has also been difficult to achieve both adequate reheated contact bondability after light exposure and sufficiently high adhesive force after curing. In addition, the conventional materials undergo volatilization of unreacted components when heat treatment is carried out after pattern formation and contact bonding with adherends, and this has tended to result in peeling of the adherends and/or contamination of elements.

The present invention has been accomplished in light of the aforementioned problems of prior art, and it is an object thereof to provide a photosensitive adhesive composition having excellent pattern formability with alkali developing solutions, a satisfactory re-adhesion property after light exposure, and an excellent low-temperature attachment property when formed into a film.

It is another object of the invention to provide a film-like adhesive having excellent pattern formability with alkali developing solutions, a satisfactory re-adhesion property after light exposure and an excellent low-temperature attachment property, and a method for forming an adhesive pattern.

It is yet another object of the invention to provide an adhesive sheet, a semiconductor wafer with an adhesive

layer, a semiconductor device and a method for manufacturing a semiconductor device, which can contribute to increased efficiency for semiconductor device assembly processes.

Means for Solving the Problems

In order to achieve the objects stated above, the invention provides a photosensitive adhesive composition that comprises (A) an alkali-soluble polymer, (B) a thermosetting resin, (C) one or more radiation-polymerizable compounds and (D) a photoinitiator, wherein the 5% weight reduction temperature of the mixture of all of the radiation-polymerizable compounds in the composition is 200°C or higher.

According to the photosensitive adhesive composition of the invention having the construction described above, it is possible to achieve high levels for pattern formability with alkali developing solutions and re-adhesion property after light exposure and to obtain an excellent low-temperature attachment property when it is formed into a film.

The (C) radiation-polymerizable compound in the photosensitive adhesive composition of the invention preferably contains a compound with a urethane and/or isocyanurate group. This can further improve the adhesion after curing.

The (C) radiation-polymerizable compound in the photosensitive adhesive composition of the invention also preferably contains an acrylate compound and/or methacrylate compound. This can further improve the pattern formability with irradiation.

The (C) radiation-polymerizable compound in the photosensitive adhesive composition of the invention also preferably contains a trifunctional or greater acrylate compound. This can further improve the adhesion after curing and inhibit outgas during heating.

The (C) radiation-polymerizable compound in the photosensitive adhesive composition of the invention also preferably contains an ethylene oxide isocyanurate-modified di- or triacrylate represented by the following general formula (I). This will allow particularly satisfactory adhesion and heat resistance to be obtained after curing.

[Chemical Formula 1]

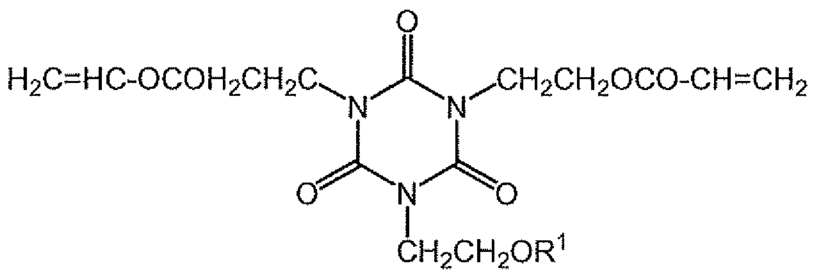

(I)

[In formula (I), $R^1$ represents hydrogen or $-COCH=CH_2$.]

The (B) thermosetting resin in the photosensitive adhesive composition of the invention preferably contains an epoxy resin. This can further improve the high-temperature adhesion.

Also, the glass transition temperature of the (A) alkali-soluble polymer in the photosensitive adhesive composition of the invention is preferably no higher than 150°C. This will result in a more satisfactory low-temperature attachment property when the composition is formed into a film.

The (A) alkali-soluble polymer in the photosensitive adhesive composition of the invention is preferably a resin with a carboxyl and/or hydroxyl group. This will provide more satisfactory pattern formability with alkali developing solutions.

The (A) alkali-soluble polymer in the photosensitive adhesive composition of the invention is preferably a polyimide resin. This will allow more satisfactory high-temperature adhesion and heat resistance to be obtained after curing.

Also, the polyimide resin referred to here is preferably a polyimide resin obtained by reaction between a tetracarboxylic dianhydride and a diamine with a carboxyl and/or hydroxyl group in the molecule.

The polyimide resin is preferably a polyimide resin obtained by reacting a tetracarboxylic dianhydride with an aromatic diamine represented by the following formula (II) and/or an aromatic diamine represented by the following formula (III).

[Chemical Formula 2]

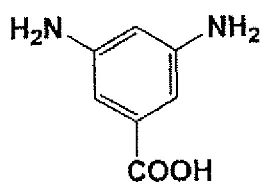

(II)

[Chemical Formula 3]

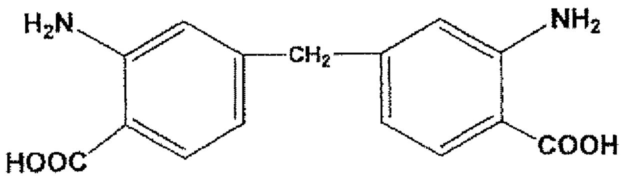

(III)

The invention also provides a film-like adhesive obtained by shaping the photosensitive adhesive composition of the invention into a film. Since this type of film-like adhesive comprises an adhesive composition according to the invention, it is possible to achieve high levels of pattern formability with alkali developing solutions, re-adhesion property after light exposure and low-temperature attachment property.

The invention still further provides an adhesive sheet comprising a base and an adhesive layer composed of a photosensitive adhesive composition according to the invention as described above, formed on one side of the base. Since this type of adhesive sheet comprises an adhesive layer composed of an adhesive composition according to the invention, and therefore comprises an adhesive composition according to the invention, it is possible to achieve high levels of the pattern formability with alkali developing solutions, the re-adhesion property after light exposure and the low-temperature attachment property. Moreover, it is easily manageable and therefore contributes to increased efficiency in the semiconductor device assembly process.

The invention still further provides an adhesive sheet having a laminated structure obtained by laminating a film-like adhesive according to the invention with a dicing sheet. Since this type of adhesive sheet comprises the dicing sheet, the adhesive sheet not only exhibits the effect of an adhesive sheet of the invention, but also exhibits both the function of a die bond film and the function of a dicing sheet, thereby further contributing to efficiency of the semiconductor device assembly process.

The invention still further provides a method for forming an adhesive pattern whereby an adhesive layer composed of a photosensitive adhesive composition of the invention is formed on an adherend, the adhesive layer is exposed to light through a photomask, and the exposed adhesive layer is developed with an alkali developing solution. The method for forming an adhesive pattern can produce high definition patterns.

The invention still further provides a semiconductor wafer with an adhesive layer, that comprises a semiconductor wafer and an adhesive layer composed of a photosensitive adhesive composition according to the invention, formed on one side of the semiconductor wafer. Since such a semiconductor wafer with an adhesive layer is provided with an adhesive layer comprising an adhesive composition according to the invention, it is possible to obtain an excellent low-temperature attachment property and thus contribute to increased efficiency of the semiconductor device assembly process.

The invention still further provides a semiconductor device having a structure with a semiconductor element and a semiconductor element-mounting supporting member bonded together using a photosensitive adhesive composition according to the invention.

The invention still further provides a method for manufacturing a semiconductor device, comprising a step of bonding a semiconductor element and a semiconductor element-mounting supporting member using a photosensitive adhesive composition according to the invention.

Since the semiconductor device and method for manufacturing it employ a photosensitive adhesive composition of the invention, it is possible to obtain semiconductor devices with excellent high-temperature adhesion and excellent

reliability.

## Effect of the Invention

According to the invention it is possible to provide a photosensitive adhesive composition having excellent pattern formability with alkali developing solutions, a satisfactory re-adhesion property after light exposure, and an excellent low-temperature attachment property when formed into a film. It is also possible according to the invention to provide a film-like adhesive having excellent pattern formability with alkali developing solutions, a satisfactory re-adhesion property after light exposure and an excellent low-temperature attachment property, and a method for forming an adhesive pattern. It is further possible according to the invention to provide an adhesive sheet, a semiconductor wafer with an adhesive layer, a semiconductor device and a method for manufacturing a semiconductor device, which can contribute to increased efficiency for semiconductor device assembly processes.

## Brief Description of the Drawings

[Fig. 1 is a schematic cross-sectional view showing an embodiment of a film-like adhesive according to the invention.
Fig. 2 is a schematic cross-sectional view showing an embodiment of an adhesive sheet according to the invention.
Fig. 3 is a schematic cross-sectional view showing another embodiment of an adhesive sheet of the invention.
Fig. 4 is a schematic cross-sectional view showing another embodiment of an adhesive sheet of the invention.
Fig. 5 is a top view showing an embodiment of a semiconductor wafer with an adhesive layer according to the invention.
Fig. 6 is an end view of Fig. 5 along line IV-IV.
Fig. 7 is a top view showing an embodiment of an adhesive pattern according to the invention.
Fig. 8 is an end view of Fig. 7 along line V-V.
Fig. 9 is a top view showing an embodiment of an adhesive pattern according to the invention.
Fig. 10 is an end view of Fig. 9 along line VI-VI.
Fig. 11 is a schematic cross-sectional view showing an embodiment of a semiconductor device according to the invention.
Fig. 12 is a schematic cross-sectional view showing another embodiment of a semiconductor device according to the invention.
Fig. 13 is a schematic diagram of a peel strength tester.

<u>Explanation of Symbols</u>

1: Film-like adhesive (adhesive layer), 1a, 1b: adhesive patterns, 2: cover film, 3: base film (base material), 6: pressure-sensitive adhesive layer, 7: base film, 8: semiconductor wafer, 12, 12a, 12b: semiconductor elements, 13: semiconductor element-mounting supporting member, 14: wire, 15: sealing material, 16: terminal, 20, 20a, 20b: semiconductor wafers with adhesive layers, 100, 110, 120: adhesive sheets, 200, 210: semiconductor devices.

## Best Mode for Carrying Out the Invention

Preferred embodiments of the invention will now be explained in detail, with reference to the accompanying drawings as necessary. Identical or corresponding parts in the drawings will be referred to by like reference numerals and will be explained only once. Unless otherwise specified, the vertical and horizontal positional relationships are based on the positional relationships in the drawings. Also, the dimensional proportions depicted in the drawings are not necessarily limitative.

The photosensitive adhesive composition of the invention comprises (A) an alkali-soluble polymer, (B) a thermosetting resin, (C) one or more radiation-polymerizable compounds and (D) a photoinitiator, wherein the 5% weight reduction temperature of the mixture of all of the radiation-polymerizable compounds in the composition is 200°C or higher.

The 5% weight reduction temperature is the 5% weight reduction temperature as measured for a sample using a differential thermal/thermogravimetric simultaneous measurement apparatus (TG/DTA6300., trade name of SII NanoTechnology Inc.) with a temperature-elevating rate of 10°C/min and under a nitrogen flow (400 ml/min).

The (C) radiation-polymerizable compound will be explained first. The (C) radiation-polymerizable compound consists of one or more compounds selected so that the 5% weight reduction temperature of the mixture of all of the radiation-polymerizable compounds in the photosensitive composition is 200°C or higher, and it is not particularly restricted so long as it is a compound that polymerizes and/or cures by exposure to radiation such as ultraviolet rays or

an electron beam. The (C) radiation-polymerizable compound also comprises at least one radiation-polymerizable compound with a 5% weight reduction temperature of 200°C or higher. As specific examples of radiation-polymerizable compounds with a 5% weight reduction temperature of 200°C or higher there may be mentioned bisphenol A-EO-modified diacrylates represented by the following general formula (IV) and bisphenol F-EO-modifed diacrylates, as well as isocyanuric acid-modified di- and triacrylates, isocyanuric acid-modified triacrylates, ε-caprolactone-modified tris(acryloxyethyl)isocyanurates represented by the following general formula (V), or pentaerythritol pentaacrylates, pentaerythritol tetraacrylates, pentaerythritol pentamethacrylates, pentaerythritol tetramethacrylates, dipentaerythritol hexaacrylates, dipentaerythritol hexamethacrylates, ditrimethylolpropane tetraacrylates, epoxy acrylates, polyether acrylates, polyester acrylates, acryl acrylates, urethane acrylates, urethane methacrylates and urea acrylates. Any of these may be used alone or in combinations of two or more.

[Chemical Formula 4]

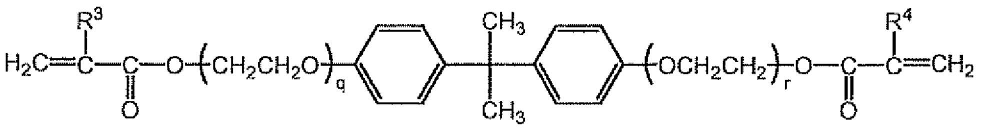

(IV)

[In formula (IV), $R^3$ and $R^4$ each independently represent hydrogen or a methyl group, and q and r each independently represent an integer of 1 or greater.]

[Chemical Formula 5]

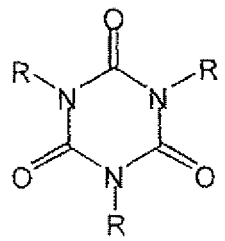

(V)

[In formula (V), R represents a C0-30 organic group containing a methacrylate or acrylate group.]

The aforementioned urethane acrylates and urethane methacrylates are produced, for example, by reaction of diols, isocyanate compounds represented by the following general formula (VI) and compounds represented by the following general formula (VII).

[Chemical Formula 6]

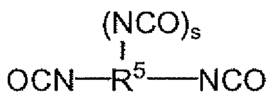

(VI)

[In formula (VI), s represents 0 or 1 and $R^5$ represents a Cl-30 divalent or trivalent organic group.]

[Chemical Formula 7]

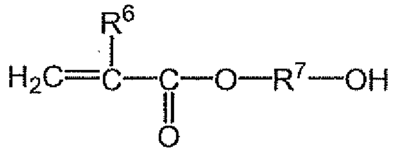

(VII)

[In formula (VII), $R^6$ represents hydrogen or a methyl group, and $R^7$ represents an ethylene or propylene group.]

The aforementioned urea methacrylates are produced, for example, by reaction of a diamine represented by the following general formula (VIII) and a compound represented by the following general formula (IX).

[Chemical Formula 8] $H_2N\text{-}R^8\text{-}NH_2$ (VIII)

[In formula (VIII), $R^8$ represents a C2-30 divalent organic group.]

[Chemical Formula 9]

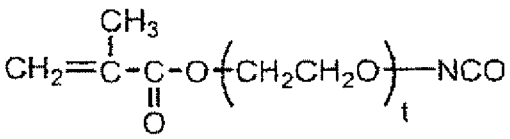

(IX)

[In formula (IX), t represents 0 or 1.]

In addition to these compounds, there may be used radiation-polymerizable copolymers having ethylenic unsaturated groups on side chains, which are obtained by addition reaction of a compound having at least one ethylenic unsaturated group and a functional group such as an oxirane ring or an isocyanate, hydroxyl or carboxyl group, with a functional group-containing vinyl copolymer.

These radiation-polymerizable compounds may be used alone or in combinations of two or more. Of these, radiation-polymerizable compounds represented by general formula (IV) above are preferred from the standpoint of imparting post-curing solvent resistance.

The isocyanuric acid-modified acrylates, isocyanuric acid-modified methacrylates represented by general formula (V), urethane acrylates and urethane methacrylates above are also preferred from the standpoint of imparting post-curing high adhesion. Any of these may be used alone or in combinations of two or more different compounds. The combined use of a radiation-polymerizable compound represented by general formula (IV) and an acrylate compound and/or methacrylate compound with a urethane and/or isocyanurate group is particularly preferred to effectively exhibit the effects of the compounds.

The (C) radiation-polymerizable compound is most preferably an ethylene oxide isocyanurate-modified di- or triacrylate represented by the following general formula (I) among the compounds represented by general formula (V) above, to further improve the post-curing adhesion.

[Chemical Formula 10]

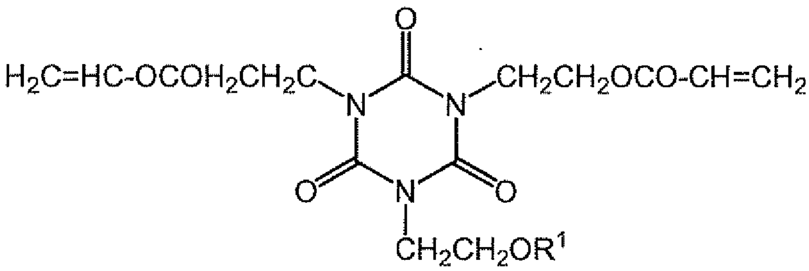

(I)

[In formula (1), $R^1$ represents hydrogen or $-COCH=CH_2$.]

The (C) radiation-polymerizable compound may contain another radiation-polymerizable compound in addition to the radiation-polymerizable compound with a 5% weight reduction temperature of 200°C or higher. Such other radiation-polymerizable compounds are radiation-polymerizable compounds with a 5% weight reduction temperature of below 200°C, and as examples there may be mentioned N-acryloyloxyethylhexahydrophthalimide, glycidyl methacrylate, monofunctional acrylates such as glycidyl acrylate, urethane methacrylate, urethane acrylate, polyether acrylate, polyester acrylate and the like.

There are no particular restrictions on the proportion of the contents of the radiation-polymerizable compound with a 5% weight reduction temperature of 200°C or higher and the radiation-polymerizable compound with a 5% weight reduction temperature of below 200°C in the photosensitive adhesive composition of the invention, but from the viewpoint of obtaining a more satisfactory effect of the invention, the proportion of the radiation-polymerizable compound with a 5% weight reduction temperature of 200°C or higher of the total radiation-polymerizable compounds is preferably at least 40 mass%, more preferably at least 70 mass% and most preferably at least 100 mass%.

From the viewpoint of reducing outgas due to the thermal history after thermocompression bonding, thermosetting and bonding to the adherend, the 5% weight reduction temperature of the mixture of all of the radiation-polymerizable compounds in the composition for the (C) radiation-polymerizable compound must be 200°C or higher, and it is more preferably 250°C or higher and even more preferably 300°C or higher. There are no particular restrictions on such (C) radiation-polymerizable compounds, but among those mentioned above it is preferred to use polyfunctional acrylates that polymerize by heat and most preferably trifunctional or greater acrylate compounds, from the viewpoint of obtaining a higher 5% weight reduction temperature.

The content of the (C) radiation-polymerizable compound in the photosensitive adhesive composition of the invention is preferably 5-200 parts by mass and more preferably 10-100 parts by mass with respect to 100 parts by mass of the (A) alkali-soluble polymer. A content of greater than 200 parts by mass for the (C) radiation-polymerizable compound will tend to lower the flow property during heat-fusion due to polymerization, thus reducing the adhesion during thermocompression bonding. A content of less than 5 parts by mass will tend to lower the solvent resistance after the photocuring by exposure, thus interfering with formation of the pattern, and therefore neither extreme is desirable.

The (A) alkali-soluble polymer composing the photosensitive adhesive composition of the invention is not particularly restricted so long as it is a polymer with an alkali-soluble group. As the (A) alkali-soluble polymer there are preferred thermoplastic resins having a carboxyl and/or hydroxyl group as the alkali-soluble group, and preferred examples are one or more resins selected from the group consisting of polyimide resins, polyamide resins, polyamideimide resins, polyetherimide resins, polyurethaneimide resins, polyurethaneamideimide resins, siloxanepolyimide resins, polyesterimide resins and their copolymers or precursors (polyamide acids), and polybenzooxazole resins, phenoxy resins, phenol-novolac resins, polysulfone resins, polyethersulfone resins, polyphenylene sulfide resins, polyester resins, polyetherketone resins, and (meth)acrylic copolymers with weight-average molecular weights of 10,000-1,000,000. The polyimide resins mentioned below are preferred among these.

The photosensitive adhesive composition of the invention is used as a film-like adhesive or used in combination with other member as an adhesive sheet and applied in a semiconductor wafer or the like, and the attachment temperature for the film-like adhesive onto a wafer back side is preferably 20-200°C, more preferably 20-150°C and most preferably 25-100°C, from the viewpoint of inhibiting warping of the semiconductor wafer.

In order to allow attachment in this temperature range, the Tg of the film-like adhesive is preferably no higher than 150°C. The glass transition temperature (Tg) of the (A) thermoplastic resin used in the photosensitive adhesive composition is therefore preferably no higher than 150°C, more preferably between -20 and 100°C and most preferably between -20 and 80°C. If the Tg of the (A) thermoplastic resin is higher than 150°C, the attachment temperature onto wafer back sides may increase above 200°C and warping of wafer back sides will tend to occur more easily, while if the

Tg is below -20°C the tack property of the film surface in the B-stage state will be too strong, tending to impair the manageability. Also, the composition of the polyimide resin described hereunder is preferably designed so that the Tg is no higher than 150°C.

The weight-average molecular weight of the (A) alkali-soluble polymer is preferably limited to within the range of 10,000-300,000, more preferably 10,000-100,000 and even more preferably 10,000-80,000. If the weight-average molecular weight is within this range, the strength, flexibility and tack properties of the photosensitive adhesive composition formed into a sheet or film will be satisfactory. Because of the satisfactory hot flow property, it is possible to ensure a satisfactory embedding property into wiring steps on board surfaces. If the weight-average molecular weight is less than 10,000 the film formability will tend to be impaired, while if it is greater than 300,000 the hot flow property will tend to be poor, and the solubility of the (A) alkali-soluble polymer in alkali developing solutions will tend to be lower, and therefore neither extreme is desirable.

If the Tg and weight-average molecular weight of the (A) alkali-soluble polymer are within these ranges, it will be possible to lower the attachment temperature onto wafer back sides while also lowering the heating temperature for adhesive anchoring of the semiconductor element to the semiconductor element-mounting supporting member (die bonding temperature) and limit increase in warping of the semiconductor element. It will also be possible to effectively impart a flow property and developing property for die bonding.

The Tg is the primary dispersion peak temperature when the (A) alkali-soluble polymer is formed into a film, and the primary dispersion temperature is obtained by measurement of the tanδ peak temperature near Tg using an "RSA-2" viscoelasticity analyzer (trade name) by Rheometrix, under conditions with a temperature-elevating rate of 5°C/min, a frequency of 1 Hz and a measuring temperature of between - 150 and 300°C. The weight-average molecular weight is the weight-average molecular weight measured in terms of polystyrene using a "C-R4A" high-performance liquid chromatograph (trade name) by Shimadzu Corp.

The alkali-soluble group of the (A) alkali-soluble polymer may be a carboxyl group or hydroxyl group as mentioned above, but a carboxyl group is preferred from the standpoint of obtaining a satisfactory developing property. The (A) alkali-soluble polymer is preferably a polymer having the alkali-soluble groups on the ends or side chains. The hydroxyl groups are preferably phenolic hydroxyl groups.

As mentioned above, a polyimide resin is preferably used as the (A) alkali-soluble polymer. The polyimide resin may be obtained, for example, by condensation reaction of a tetracarboxylic dianhydride and diamine by a known process.

Specifically, the compositional ratio is adjusted so that the tetracarboxylic dianhydride and diamine are in equimolar amounts in the organic solvent, or if necessary so that the total of diamines is in the range of preferably 0.5-2.0 mol and more preferably 0.8-1.0 mol with respect to 1.0 mol as the total tetracarboxylic dianhydrides (with any desired order of addition of the components), and addition reaction is conducted with a reaction temperature of no higher than 80°C and preferably 0-60°C.

The viscosity of the reaction mixture will gradually increase as the reaction proceeds, forming polyamide acid as the polyimide resin precursor. In order to prevent reduction in the properties of the adhesive composition, the tetracarboxylic dianhydride is preferably one that has been subjected to recrystallizing purifying treatment with acetic anhydride.

If total diamines exceed 2.0 mol with respect to 1.0 mol as the total tetracarboxylic dianhydrides, in the compositional ratio of the tetracarboxylic dianhydride and diamine components for the condensation reaction, the amount of amine-terminal polyimide oligomers in the obtained polyimide resin will tend to be greater, and if the total diamines is less than 0.5 mol the amount of acid-terminal polyimide oligomers will tend to be greater, while in both cases the weight-average molecular weight of the polyimide resin will be lowered, thus tending to reduce the properties of the adhesive composition, including the heat resistance.

The charging compositional ratio for the tetracarboxylic dianhydrides and diamines is preferably determined as appropriate so that the weight-average molecular weight of the obtained polyimide resin is 10,000-300,000.

The polyimide resin may be obtained by dehydrating cyclization of the reaction product (polyamide acid). Dehydrating cyclization can be accomplished by thermal cyclization using heat treatment or by chemical cyclization using a dehydrating agent.

There are no particular restrictions on tetracarboxylic dianhydrides to be used as starting materials for the polyimide resin, and as examples there may be mentioned pyromellitic acid dianhydride, 3,3', 4,4'-biphenyltetracarboxylic dianhydride, 2,2', 3,3'-biphenyltetracarboxylic dianhydride, 2,2-bis(3,4-dicarboxyphenyl)propane dianhydride, 2,2-bis (2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylenetetracarboxylic dianhydride, bis(3,4-dicarboxyphenyl) ether dianhydride, benzene-1,2,3,4-tetracarboxylic dianhydride, 3,4,3',4'-benzophenonetetracarboxylic dianhydride, 2,3,2',3'-benzophenonetetracarboxylic dianhydride, 3,3,3',4'-benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,4,5-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,5,6-tetracarboxylic dianhydride, 2,3,3',4'-biphenyltetracarboxylic dianhydride, 3,4,3',4'-biphenyltetracarboxylic dianhydride, 2,3,2',3'-biphenyltetracarboxylic dianhydride, bis(3,4-dicarboxyphenyl)dimethylsilane dianhydride, bis (3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, p-phenylenebis(trimellitate anhydride), ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetracarboxylic dianhydride, bis(exo-bicyclo[2,2,1]heptane-2,3-dicarboxylic dianhydride, bicyclo-[2,2,2]-oct-7-ene-2,3,5,6-tetracarboxylic dianhydride, 2,2-bis(3,4-dicarboxyphenyl)propane dianhydride, 2,2-bis[4-(3,4-dicarboxyphenyl)phenyl]propane dianhydride, 2,2-bis(3,4-dicarboxyphenyl)hexafluoropropane dianhydride, 2,2,-bis[4-(3,4-dicarboxyphenyl)phenyl]hexafluoropropane dianhydride, 4,4'-bis(3,4-dicarboxyphenoxy) diphenyl sulfide dianhydride, 1,4-bis(2-hydroxyhexafluoroisopropyl)benzenebis(trimellitic anhydride), 1,3-bis(2-hydxoxyhexafluoroisopropyl)benzenebis(trimellitic anhydride), 5-(2,5-dioxotetrahydrofuryl)-3-methyl-3-cyclohexene-1,2-dicarboxylic dianhydride, tetrahydrofuran-2,3,4,5-tetracarboxylic dianhydride, and tetracarboxylic dianhydrides represented by the following general formula (X).

[Chemical Formula 11]

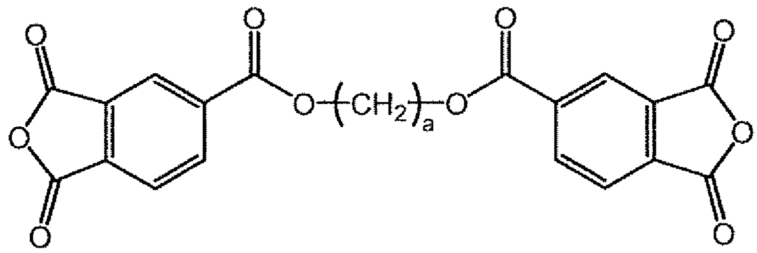

(X)

[In the formula, a represents an integer of 2-20.]

The tetracarboxylic dianhydrides represented by general formula (X) above can be synthesized, for example, from trimellitic anhydride monochloride and its corresponding diol, and specifically there may be mentioned 1,2-(ethylene) bis(trimellitate anhydride), 1,3-(trimethylene)bis(trimellitate anhydride), 1,4-(tetramethylene)bis(trimellitate anhydride), 1,5-(pentamethylene)bis(trimellitate anhydride), 1,6-(hexamethylene)bis(trimellitate anhydride), 1,7-(heptamethylene) bis(trimellitate anhydride), 1,8-(octamethylene)bis(trimellitate anhydride), 1,9-(nonamethylene)bis(trimellitate anhydride), 1,10-(decamethylene)bis(trimellitate anhydride), 1,12-(dodecamethylene)bis(trimellitate anhydride), 1,16-(hexadecamethylene)bis(trimellitate anhydride) and 1,18-(octadecamethylene)bis(trimellitate anhydride).

As tetracarboxylic dianhydrides there are preferred tetracarboxylic dianhydrides represented by the following formula (XI) or (XII), from the viewpoint of imparting satisfactory solubility in the solvent and satisfactory moisture-proof reliability.

[Chemical Formula 12]

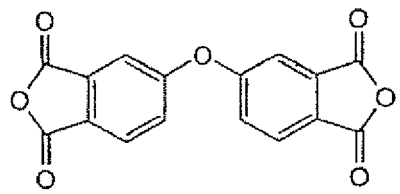

(XI)

[Chemical Formula 13]

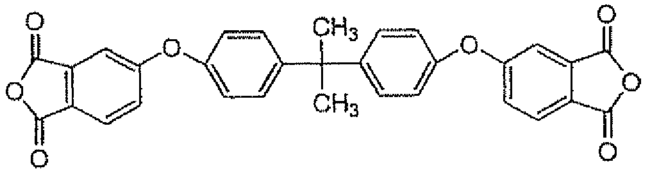

(XII)

These tetracarboxylic dianhydrides may be used alone or in combinations of two or more.

The diamines used as starting materials for the polyimide resin preferably include an aromatic diamine represented by the following general formula (XIII), (XIV), (XV) or (XVI). The aromatic diamines represented by the following formulas (XIII)-(XVI) preferably constitute 1-50 mol% of the total diamines. It will thus be possible to prepare a polyimide that is soluble in the alkali developing solution. If the aromatic diamine content is less than 1 mol% the solubility in the alkali developing solution will tend to be lower, and if it is greater than 50 mol% the adhesive layer will be more prone to peeling from the adherend during development.

[Chemical Formula 14]

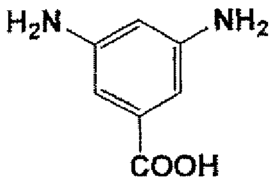

(XIII)

[Chemical Formula 15]

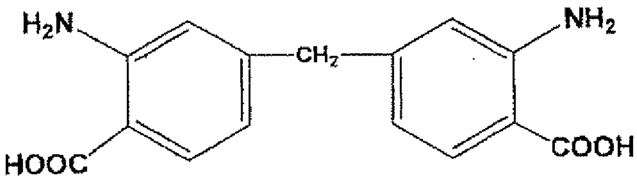

(XIV)

[Chemical Formula 16]

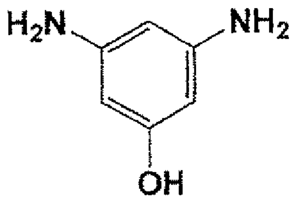

(XV)

[Chemical Formula 17]

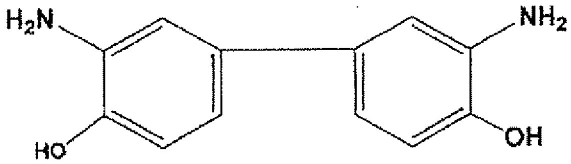

(XVI)

There are no particular restrictions on other diamines to be used as starting materials for the polyimide resin, and as examples there may be mentioned aromatic diamines such as o-phenylenediamine, m-phenylenediamine, p-phenylenediamine, 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylethermethane, bis(4-amino-3,5-dimethylphenyl)methane, bis(4-amino-3,5-diisopropylphenyl)methane, 3,3'-diaminodiphenyldifluoromethane, 3,4'-diaminodiphenyldifluoromethane, 4,4'-diaminodiphenyldifluoromethane, 3,3'-diaminodiphenylsulfone, 3,4'-diaminodiphenylsulfone, 4,4'-diaminodiphenylsulfone, 3,3'-diaminodiphenyl sulfide, 3,4'-diaminodiphenyl sulfide, 4,4'-diaminodiphenyl sulfide, 3,3'-diaminodiphenylketone, 3,4'-diaminodiphenylketone, 4,4'-diaminodiphenylketone, 2,2-bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3-bis(3-aminophenoxy) benzene, 1,4-bis(3-aminophenoxy)benzene, 1,4-bis(4-aminophenoxy)benzene, 3,3'-[1,4-phenylenebis(1-methylethylidene)]bisaniline, 3,4'-[1,4-phenylenebis(1-methylethylidene)]bisaniline, 4,4'-[1,4-phenylenebis(1-methylethylidene)] bisaniline, 2,2-bis[4-(3-aminophenoxy)phenyl]propane, 2,2-bis[4-(3-aminophenoxy)phenyl]hexafluoropropane, 2,2-bis [4-(4-aminophenoxy)phenyl]hexafluoropropane, bis[4-(3-aminoenoxy)phenyl] sulfide, bis[4-(4-aminoenoxy)phenyl] sulfide, bis[4-(3-aminoenoxy)phenyl]sulfone, bis[4-(4-aminoenoxy)phenyl]sulfone, 3,3'-dihydroxy-4,4'-diaminobiphenyl, 3,5-diaminobenzoic acid and the like, 1,3-bis(aminomethyl)cyclohexane, 2,2-bis(4-aminophenoxyphenyl)propane, aliphatic etherdiamines represented by the following general formula (XVII), aliphatic diamines represented by the following general formula (XIX), and siloxanediamines represented by the following general formula (XX).

[Chemical Formula 18] $H_2N\text{-}Q^1\{O\text{-}Q^2\}_b\text{-}O\text{-}Q^3\text{-}NH_2$ (XVIII)

[In the formula, $Q_1$, $Q_2$ and $Q_3$ each independently represent a C1-10 alkylene group, and b represents an integer of 2-80.]

[Chemical Formula 19] $H_2N\{CH_2\}NH_2$ (XIX)

[In the formula, c represents an integer of 5-20.]

[Chemical Formula 20]

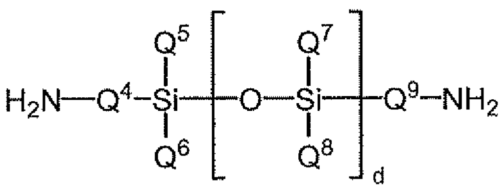

(XX)

[In the formula, $Q^4$ and $Q^9$ each independently represent a C1-5 alkylene or optionally substituted phenylene group, $Q^5$, $Q^6$, $Q^7$ and $Q^8$ each independently represent a C1-5 alkyl, phenyl or phenoxy group, and d represents an integer of 1-5.]

As specific aliphatic etherdiamines represented by general formula (XVII) above there may be mentioned aliphatic diamines represented by the following formula:

[Chemical Formula 21]

$H_2N{-}(CH_2)_3{-}O{-}(CH_2)_4{-}O{-}(CH_2)_3{-}NH_2$

$H_2N{-}(CH_2)_3{-}O{-}(CH_2)_2{-}O{-}(CH_2)_2{-}O{-}(CH_2)_3{-}NH_2$

$H_2N{-}(CH_2)_3{-}O{-}(CH_2)_2{-}O{-}(CH_2)_2{-}O{-}(CH_2)_2{-}O{-}(CH_2)_3{-}NH_2$

$H_2N{-}(CH_2)_3{-}[O{-}(CH_2)_4]_n{-}O{-}(CH_2)_3{-}NH_2$ Mw=350

$H_2N{-}(CH_2)_3{-}[O{-}(CH_2)_4]_n{-}O{-}(CH_2)_3{-}NH_2$ Mw=750

$H_2N{-}(CH_2)_3{-}[O{-}(CH_2)_4]_n{-}O{-}(CH_2)_3{-}NH_2$ Mw=1100

$H_2N{-}(CH_2)_3{-}[O{-}(CH_2)_4]_n{-}O{-}(CH_2)_3{-}NH_2$ Mw=2100

$H_2N{-}CH(CH_3){-}(CH_2){-}[O{-}CH(CH_3){-}(CH_2)]_n{-}O{-}(CH_2){-}CH(CH_3){-}NH_2$ Mw=230

$H_2N{-}CH(CH_3){-}(CH_2){-}[O{-}CH(CH_3){-}(CH_2)]_n{-}O{-}(CH_2){-}CH(CH_3){-}NH_2$ Mw=400

$H_2N{-}CH(CH_3){-}(CH_2){-}[O{-}CH(CH_3){-}(CH_2)]_n{-}O{-}(CH_2){-}CH(CH_3){-}NH_2$ Mw=2000

and aliphatic etherdiamines represented by the following formula (XVIII).

[Chemical Formula 22]

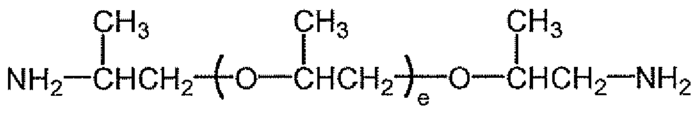 (XVIII)

[In the formula, e represents an integer of 0-80.]

As specific aliphatic diamines represented by general formula (XIX) above there may be mentioned 1,2-diaminoethane, 1,3-diaminopropane, 1,4-diaminobutane, 1,5-diaminopentane, 1,6-diaminohexane, 1,7-diaminoheptane, 1,8-diaminooctane, 1,9-diaminononane, 1,10-diaminodecane, 1,11-diaminoundecane, 1,12-diaminododecane and 1,2-diaminocyelohexane.

As specific siloxanediamines represented by general formula (XX) above there may be mentioned, where d in formula (XX) is 1: 1,1,3,3-tetramethyl-1,3-bis(4-aminophenyl)disiloxane, 1,1,3,3-tetraphenoxy-1,3-bis(4-aminoethyl)disiloxane, 1,1,3,3-tetraphenyl-1,3-bis(2-aminoethyl)disiloxane, 1,1,3,3-tetraphenyl-1,3-bis(3-aminopropyl)disiloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(3-aminobutyl)disiloxane and 1,3-dimethyl-1,3-dimethoxy-1,3-bis(4-aminobutyl)disiloxane, and where d is 2: 1,1,3,3,5,5-hexamethyl-1,5-bis(4-aminophenyl)trisiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisiloxane, 1, 1,5,5-tetramethyl-3,3-dimethoxy-1,5-bis(2-aminoethyl)trisiloxane, 1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3,3,5,5-hexaethyl-1,5-bis(3-aminopropyl)trisiloxane and 1,1,3,3,5,5-hexapropyl-1,5-bis(3-aminopropyl)trisiloxane.

These diamine may be used alone or in combinations of two or more.

The above-mentioned polyimide resins may be used alone, or if necessary they may be used as mixtures (blends) of two or more different types.

As mentioned above, the composition of the polyimide resin is preferably designed so that the Tg is no higher than 150°C, and from this viewpoint, the diamine used as a starting material for the polyimide resin is preferably an aliphatic etherdiamine represented by general formula (XVIII) above. As specific aliphatic etherdiamines represented by general formula (XVIII) there may be mentioned aliphatic diamines including polyoxyalkylenediamines such as JEFFAMINE D-230, D-400, D-2000, D-4000, ED-600, ED-900, ED-2000 and EDR-148 by San Techno Chemical Co., Ltd., and polyetheramine D-230, D-400 and D-2000 by BASF. These diamines constitute preferably 0-80 mol% and more

preferably 5-60 mol% of the total diamines. If the amount is less than 5 mol% it will tend to be difficult to impart low-temperature adhesion and a hot flow property, while if it is greater than 60 mol% the Tg of the polyimide resin will be too low, tending to impair the autosupporting property of the film.

The polyimide resin can be obtained by reacting a tetracarboxylic dianhydride with a diamine having carboxyl and amino groups. This will result in introduction of the carboxyl groups from the diamine into the polyimide resin. By appropriately adjusting the type of diamine, the charging ratio and the reaction conditions, it is possible to obtain a polyimide resin with a Tg of no higher than 150°C and an Mw of 5000-150,000.

The content of the (A) alkali-soluble polymer in the photosensitive adhesive composition of the invention is preferably 10-90 mass% and more preferably 20-80 mass% based on the total solid mass of the photosensitive adhesive composition. If the content is less than 10 mass% the film formability, pattern formability and adhesion will tend to be reduced, while if it is greater than 90 mass% the humidity resistance, pattern formability and adhesion will tend to be reduced.

As examples for the (B) thermosetting resin to be used for the invention there may be mentioned epoxy resins, cyanate resins, bismaleimide resins, phenol resins, urea resins, melamine resins, alkyd resins, acrylic resins, unsaturated polyester resins, diallyl phthalate resins, silicone resins, resorcinolformaldehyde resins, xylene resins, furan resins, polyurethane resins, ketone resins, triallyl cyanurate resins, polyisocyanate resins, tris(2-hydroxyethyl)isocyanurate-containing resins, triallyl trimellitate-containing resins, thermosetting resins synthesized from cyclopentadiene and thermosetting resins obtained by trimerization of aromatic dicyanamides, as well as compounds with amino, isocyanato, oxazoline, carbodiimide or epoxy groups as compounds that undergo thermal reaction with the carboxyl and/or hydroxyl groups of alkali-soluble resins.

Among these, epoxy resins, cyanate resins and bismaleimide resins are preferred from the viewpoint of imparting excellent adhesive force at high temperature, and epoxy resins are particularly preferred from their manageability and compatibility with polyimide resins. More preferred from the viewpoint of pot life, adhesion and outgas are compounds with number-average molecular weights of 1000 and greater, and as such compounds there may be mentioned oxazoline group-containing polymers, carbodiimide polymers and the like, with oxazoline group-containing polymers being preferred from the viewpoint of imparting hydrolysis resistance. These thermosetting resins may be used alone or in combinations of two or more.

The epoxy resin is preferably one containing at least two epoxy groups in the molecule, and it is most preferably a phenol glycidyl ether-type epoxy resin from the viewpoint of curability and cured product properties. As examples of such resins there may be mentioned bisphenol A-type or AD-type, S-type or F-type glycidyl ethers, hydrogenated bisphenol A-type glycidyl ethers, ethylene oxide adduct bisphenol A-type glycidyl ethers, propylene oxide adduct bisphenol A-type glycidyl ethers, phenol-novolac resin glycidyl ethers, cresol-novolac resin glycidyl ethers, bisphenol A-novolac resin glycidyl ethers, naphthalene resin glycidyl ethers, trifunctional or tetrafunctional glycidyl ethers, dicyclopentadienephenol resin glycidyl ethers, dimer acid glycidyl esters, trifunctional or tetrafunctional glycidylamines, naphthalene resin glycidylamines, and the like. These may be used alone or in combinations of two or more types.

From the viewpoint of preventing electromigration and corrosion of metal conductor circuits, these epoxy resins are preferably high purity products with a content of no greater than 300 ppm for impurity ions such as alkali metal ions, alkaline earth metal ions and halogen ions, and particularly chloride ion or hydrolyzable chlorine.

When a thermosetting resin is used, its content is preferably 0.1-200 parts by mass and more preferably 2-50 parts by mass with respect to 100 parts by mass of the (A) alkali-soluble polymer. A (B) thermosetting resin content of greater than 200 parts by mass will tend to lower the solubility in the aqueous alkali solution and reduce the pattern formability. On the other hand, at less than 0.1 part by mass the high-temperature adhesion will tend to be lowered, and therefore neither extreme is desirable.

When an epoxy resin is used, a curing agent may be used as necessary. As examples of curing agents there may be mentioned phenol-based compounds, aliphatic amines, alicyclic amines, aromatic polyamines, polyamides, aliphatic acid anhydrides, alicyclic acid anhydrides, aromatic acid anhydrides, dicyandiamides, organic acid dihydrazides, boron trifluoride amine complexes, imidazoles, tertiary amines and the like. Phenol-based compounds are preferred among these, with phenol-based compounds having two or more phenolic hydroxyl groups in the molecule being more preferred. As examples of such compounds there may be mentioned phenol-novolac, cresol-novolac, t-butylphenol-novolac, dicyclopentadiene cresol-novolac, dicyclopentadiene phenol-novolac, xylylene-modified phenol-novolac, naphthol-based compounds, trisphenol-based compounds, tetrakisphenol-novolac, bisphenol A-novolac, poly-p-vinylphenol, phenolaralkyl resins and the like. Compounds with a number-average molecular weight in the range of 400-1500 are preferred among these. This will help minimize outgas during heating, which can cause contamination of the semiconductor element or apparatus during the heating for semiconductor device assembly.

A curing accelerator may also be used if necessary. The curing accelerator is not particularly restricted so long as it cures the epoxy resin, and as examples there may be mentioned imidazoles, dicyandiamide derivatives, dicarboxylic acid dihydrazides, triphenylphosphine, tetraphenylphosphoniumtetraphenyl borate, 2-ethyl-4-methylimidazole-tetraphenyl borate, 1,8-diazabicyclo[5.4.0]undecene-7-tetraphenyl borate. The amounts of such curing accelerators are preferably 0-50 parts by mass with respect to 100 parts by mass of the epoxy resin.

The photosensitive adhesive composition of the invention further comprises (D) a photoinitiator. As (D) photoinitiators there may be mentioned photoradical initiators that generate free radicals by irradiation, photobase generators that generate bases by irradiation and photoacid generators that generate acids by irradiation. The (D) photoinitiator is preferably one having an absorption band of 300-500 nm, in order to obtain satisfactory sensitivity. From the viewpoint of reducing outgas and improving the high-temperature adhesion, the (D) photoinitiator used preferably has a 5% weight reduction temperature of 150°C or higher.

As specific examples for the (D) photoinitiator there may be mentioned aromatic ketones such as benzophenone, N,N'-tetramethyl-4,4'-diaminobenzophenone (Michler's ketone), N,N'-tetraethyl-4,4'-diaminobenzophenone, 4-methoxy-4'-dimethylaminobenzophenone, 2-benzyl-2-dimethylamino-1-(4-morpholinophenyl)-butanone-1, 2,2-dimethoxy-1,2-diphenylethan-1-one, 1-hydroxy-cyclohexyl-phenyl-ketone, 2-methyl-1-(4-(methylthio)phenyl)-2-morpholinopropanone-1, 2,4-diethylthioxanthone, 2-ethylanthraquinone and phenanthrenequinone, benzoinethers such as benzoinmethyl ether, benzoinethyl ether and benzoinphenyl ether, benzoins such as methylbenzoin and ethylbenzoin, benzyl derivatives such as benzyldimethylketal, 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer and 2-(2,4-dimethoxyphenyl)-4,5-diphenylimidazole dimer, acridine derivatives such as 9-phenylacridine and 1,7-bis(9,9'-acridinyl)heptane, bisacylphosphine oxides such as bis(2,6-dimethoxybenzoyl)-2,4,4-trimethyl-pentylphosphine oxide and bis(2,4,6,-trimethylbenzoyl)-phenylphosphine oxide, ethanone, 1-[9-ethyl-6-(2-methylbenzoyl)-9H-carbazol-3-yl]-1-(O-acetyloxime), 1,2-octanedione, 1-[4-(phenylthio)-2-(O-benzoyloxime)], and the like. These may be used alone or in combinations of two or more types.

The photobase generator may be any compound that generates a base upon irradiation, without any particular restrictions. Strongly basic compounds are preferred as bases to be generated, from the viewpoint of reactivity and curing speed. The pKa value, which is the logarithm of the acid dissociation constant, is generally used as the index of the basicity, and the pKa value is preferably 7 or greater and more preferably 9 or greater in aqueous solution.

As examples of compounds exhibiting such basicity there may be mentioned imidazole and imidazole derivatives such as 2,4-dimethylimidazole and 1-methylimidazole, piperazine and piperazine derivatives such as 2,5-dimethylpiperazine, piperidine and piperidine derivatives such as 1,2-dimethylpiperidine, proline derivatives, trialkylamine derivatives such as trimethylamine, triethylamine and triethanolamine, pyridine derivatives with amino groups or alkylamino groups substituting at the 4-position, such as 4-methylaminopyridine or 4-dimethylaminopyridine, pyrrolidine and pyrrolidine derivatives such as n-methylpyrrolidine, alicyclic amine derivatives such as triethylenediamine and 1,8-diazabiscyclo (5,4,0)undecene-1 (DBU), and benzylamine derivatives such as benzylmethylamine, benzyldimethylamine and benzyldiethylamine.

As examples of photobase generators that generate such basic compounds by irradiation, there may be used the quaternary ammonium salt derivatives described in Journal of Photopolymer Science and Technology Vol. 12, 313-314 (1999) or Chemistry of Materials Vol. 11, 170-176 (1999). These are optimal for curing of the epoxy resin, in order to produce trialkylamines with high basicity by exposure to active light rays.

As photobase generators, there may be used the carbamic acid derivatives mentioned in Journal of American Chemical Society Vol. 118 p.12925(1996) or Polymer Journal Vol. 28 p.795(1996).

There may also be used oxime derivatives that generate primary amino groups by irradiation of active light rays, and commercially available photoradical generators such as 2-methyl-1[4-(methylthio)phenyl]-2-morpholinopropan-1-one (IRGACURE 907, product of Ciba Specialty Chemicals), 2-benzyl-2-dimethylamino-1-(4-morpholinophenyl)-butanone-1 (IRGACURE 369, product of Ciba Specialty Chemicals), hexaarylbisimidazole derivatives (with the halogen, alkoxy, nitro or cyano substituents optionally substituted with phenyl), and benzoisooxazolone derivatives.

In addition to using a base generator that responds to active light rays, the epoxy resin can also be cured by generating a basic compound by reaction such as photo Fries rearrangement, photo Claisen rearrangement, Curtius rearrangement, or Stevens rearrangement.

The base generator may be used as a low molecular compound with a molecular weight of 500 or lower, and it may even employ a compound having a base-generating group introduced on the main chain and/or a side chain of the polymer. The molecular weight in this case is preferably a weight-average molecular weight of 1,000-100,000 and more preferably 5,000-30,000, from the viewpoint of adhesion and flow property.

Since these compounds do not exhibit reactivity with the epoxy resin when not exposed to radiation at room temperature (25°C), they are characterized by having highly excellent storage stability at room temperature.

The amount of the (D) photoinitiator in the photosensitive adhesive composition of the invention is not particularly restricted, but for most purposes it is preferably 0.01-30 parts by mass with respect to 100 parts by mass of the (A) alkali-soluble polymer.

An appropriate filler may also be used in the photosensitive adhesive composition of the invention. As fillers there may be used, for example, metal fillers such as silver powder, gold dust, copper powder and nickel powder,

inorganic fillers such as alumina, aluminum hydroxide, magnesium hydroxide, calcium carbonate, magnesium carbonate, calcium silicate, magnesium silicate, calcium oxide, magnesium oxide, aluminum oxide, aluminum nitride, crystalline silica, amorphous silica, boron nitride, titania, glass, iron oxide and ceramics, and organic fillers such as carbon and rubber-based fillers, without any particular restrictions on the type or form.

The filler may be selected for use according to the desired function. For example, a metal filler is added to impart conductivity, thermal conductivity or a thixotropic property to the adhesive composition, a non-metal inorganic filler is added to impart thermal conductivity, a low thermal expansion property or low hygroscopicity to the adhesive layer, and an organic filler is added to impart toughness to the adhesive layer.

These metal fillers, inorganic fillers or organic fillers may be used alone or in combinations of two or more. Metal fillers, inorganic fillers and insulating fillers are preferred from the viewpoint of imparting conductivity, thermal conductivity, a low moisture absorption property and an insulating property, which are required for semiconductor device adhesive materials, and among inorganic fillers and insulating fillers there are preferred silica fillers from the viewpoint of satisfactory dispersibility in resin varnishes and high adhesive force when hot.

The filler preferably has a mean particle size of no greater than 10 μm and a maximum particle size of no greater than 30 μm, and more preferably a mean particle size of no greater than 5 μm and a maximum particle size of no greater than 20 μm. If the mean particle size exceeds 10 μm and the maximum particle size exceeds 30 μm, it may not be possible to satisfactorily obtain an effect of improved fracture toughness. There are no particular restrictions on the lower limits for the mean particle size and maximum particle size, but normally both will be 0.001 μm.

The filler content in the photosensitive adhesive composition of the invention may be determined according to the properties and function to be imparted, but it is preferably 0-50 mass%, more preferably 1-40 mass% and even more preferably 3-30 mass% with respect to the total of the resin component and filler. Increasing the amount of filler can increase the high elastic modulus and effectively improve the dicing property (cuttability with a dicer blade), wire bonding property (ultrasonic wave efficiency) and hot adhesive strength.

If the filler is increased above the necessary amount the thermocompression bonding property will tend to be impaired, and therefore the filler content is preferably limited to within the range specified above. The optimal filler content is determined for the desired balance of properties. In cases where a filler is used, mixing and kneading may be accomplished using an appropriate combination of dispersers such as an ordinary stirrer, kneader, triple roll, ball mill or the like.

Various coupling agents may also be added to the photosensitive adhesive composition of the invention to improve the interfacial bonding between different types of materials. As examples of coupling agents there may be mentioned silane-based, titanium-based and aluminum-based agents, among which silane-based coupling agents are preferred for a greater effect. The amount of coupling agent used is preferably 0.01-20 parts by mass with respect to 100 parts by mass of the (A) alkali-soluble polymer (thermoplastic resin) used, from the standpoint of the effect, heat resistance and cost.

An ion scavenger may also be added to the photosensitive adhesive composition of the invention to adsorb ionic impurities and improve the insulating reliability when wet. There are no particular restrictions on such ion scavengers, and as examples there may be mentioned compounds known as copper inhibitors to prevent ionization and dissolution of copper, such as triazinethiol compounds and bisphenol-based reducing agents, as well as inorganic ion adsorbents such as zirconium-based and antimony bismuth-based magnesium aluminum compounds. The amount of ion scavenger used is preferably 0.01-10 parts by mass with respect to 100 parts by mass of the (A) alkali-soluble polymer (thermoplastic resin), from the viewpoint of effect of the addition, heat resistance and cost.

Fig. 1 is a schematic cross-sectional view showing an embodiment of a film-like adhesive according to the invention. The film-like adhesive (adhesive film) 1 shown in Fig. 1 is obtained by forming a film from the photosensitive adhesive composition. Fig. 2 is a schematic cross-sectional view showing an embodiment of an adhesive sheet according to the invention. The adhesive sheet 100 shown in Fig. 2 is constructed of a base 3, and an adhesive layer composed of an adhesive film 1 formed on one side of the base. Fig. 3 is a schematic cross-sectional view showing another embodiment of an adhesive sheet of the invention. The adhesive sheet 110 shown in Fig. 3 is constructed of a base 3, and an adhesive layer composed of an adhesive film 1, and a cover film 2, formed on one side of the base.

The film-like adhesive 1 can be obtained by a method in which the (A) alkali-soluble polymer, the (B) thermosetting resin, the (C) one or more radiation-polymerizable compounds selected so that the 5% weight reduction temperature of the mixture of all of the radiation-polymerizable compounds in the composition is 200°C or higher, and the (D) photoinitiator, as well as other components added as necessary, are mixed in an organic solvent, the mixture is kneaded to prepare a varnish, and the varnish layer is formed on the base 3, after which the varnish layer is dried by heating and the base 3 is removed. They may also be stored and used as adhesive sheets 100, 110, without removal of the base 3.

The mixing and kneading can generally be accomplished by an appropriate combination of dispersers such as a stirrer, kneader, triple roll or ball mill. When the (C) thermosetting resin is used, the drying is carried out at a temperature sufficient so that the thermosetting resin does not react during drying, and under conditions at which the solvent completely volatilizes. Specifically, the varnish layer is dried by heating at usually 60-180°C for 0.1-90 minutes.

The preferred thickness of the varnish layer before drying is 1-150 μm. A thickness of less than 1 μm will tend

to impair the adhesive anchoring function, while a thickness of greater than 150 μm will tend to increase the residual volatile components described hereunder, and therefore neither extreme is desirable.

The preferred residual volatile component of the obtained varnish layer is no greater than 10 mass%. A residual volatile component of greater than 10 mass% is not desirable as it will tend to leave voids inside the adhesive layer due to foam produced by volatilization of the solvent during assembly heating and will tend to impair the humidity-resistant reliability, while also increasing the potential for contamination of the surrounding material or members due to volatilizing components generated during heating.

The conditions for measuring the residual volatilizing components were as follows. Specifically, the residual volatile content for a film-like adhesive cut to a size of 50 mm × 50 mm was the value obtained from the following formula, where M1 is the initial mass and M2 is the mass after heating the film-like adhesive for 3 hours in an oven at 160°C.

[Formula 1]

$$[(M2-M1)]/M1] \times 100 = \text{residual volatile content (\%)}$$

The temperature at which the thermosetting resin does not completely react is, specifically, a temperature below the peak temperature for heat of reaction, with measurement using a DSC (for example, a "Model DSC-7" (trade name) by Perkin-Elmer), with a sample weight of 10 mg, a temperature-elevating rate of 5°C/min and a measuring atmosphere of air.

The organic solvent used to prepare the varnish, i.e. the varnish solvent, is not particularly restricted so long as it can uniformly dissolve or disperse in the material. As examples there may be mentioned dimethylformamide, toluene, benzene, xylene, methyl ethyl ketone, tetrahydrofuran, ethylcellosolve, ethylcellosolve acetate, dioxane, cyclohexanone, ethyl acetate and N-methyl-pyrrolidinone.

The 5% weight reduction temperature of the film-like adhesive 1 formed using this varnish is preferably 180°C or higher, more preferably 220°C or higher and even more preferably 260°C or higher. A 5% weight reduction temperature of 180°C or higher can reduce outgas resulting from the thermal history after post-curing, and inhibit contamination of the semiconductor element and peeling of adherends.

The base 3 is not particularly restricted so long as it can withstand the drying conditions. For example, a polyester film, polypropylene film, polyethylene terephthalate film, polyimide film, polyetherimide film, polyether naphthalate film or methylpentene film may be used as the base 3. A film used as the base 3 may also be a multilayer film comprising a combination of two or more different types, and the surface may be treated with a silicone-based or silica-based release agent.

The film-like adhesive 1 of the invention may be laminated with a dicing sheet to form an adhesive sheet. The dicing sheet is a sheet comprising a pressure-sensitive adhesive layer formed on a base, and the pressure-sensitive adhesive layer may be a pressure-sensitive type or radiation-curing type.

The base is preferably an expandable base. Using such an adhesive sheet, it is possible to obtain an integrated dicing/die bond adhesive sheet having a function as a die bond film and also having a function as a dicing sheet.

Specifically, the integrated dicing/die bond adhesive sheet may be an adhesive sheet 120 such as shown in Fig. 4, having a base film 7, a pressure-sensitive adhesive layer 6 and a film-like adhesive 1 of the invention formed in that order.

Fig. 5 is a top view showing an embodiment of a semiconductor wafer with an adhesive layer according to the invention, and Fig. 6 is an end view of Fig. 5 along line IV-IV. The semiconductor wafer with an adhesive layer 20 shown in Figs. 5 and 6 comprises a semiconductor wafer 8, and a film-like adhesive (adhesive layer) 1 composed of the aforementioned photosensitive adhesive composition, formed on one side thereof.

The semiconductor wafer with an adhesive layer 20 is obtained by laminating the film-like adhesive 1 on the semiconductor wafer 8 while heating. Since the adhesive film 1 is a film composed of the aforementioned photosensitive adhesive composition, it can be attached to the semiconductor wafer 8 at a low temperature of, for example, between room temperature (25°C) and about 150°C.

Fig. 7 and Fig. 9 are top views showing embodiments of an adhesive pattern according to the invention, Fig. 8 is an end view of Fig. 7 along line V-V, and Fig. 10 is an end view of Fig. 9 along line VI-VI. The adhesive patterns 1a and 1b shown in Figs. 7, 8, 9 and 10 are formed on the semiconductor wafer 8 as the adherend, so as to form patterns along roughly square sides, or square patterns.

The adhesive patterns 1a and 1b are formed by forming the adhesive layer 1 composed of a photosensitive adhesive composition on the semiconductor wafer 8 as the adherend to obtain a semiconductor wafer with an adhesive layer 20, exposing the adhesive layer 1 through a photomask, and developing the exposed adhesive layer 1 with an

alkali developing solution. This will yield semiconductor wafers with adhesive layers 20a, 20b on which adhesive patterns 1a, 1b have been formed.

The use of the film-like adhesive of the invention will now be explained in detail, with reference to the drawings of semiconductor devices comprising film-like adhesives. Incidentally, semiconductor devices with various structures have been proposed in recent years, and use of the film-like adhesive of the invention is not limited to semiconductor devices having the structures described below.

Fig. 11 is a schematic cross-sectional view showing an embodiment of a semiconductor device according to the invention. In the semiconductor device 200 shown in Fig. 11, the semiconductor element 12 is bonded to the semiconductor element-mounting supporting member 13 via the film-like adhesive 1 of the invention, and the connecting terminals (not shown) of the semiconductor element 12 are electrically connected to the external connecting terminals (not shown) via wires 14, and sealed with a sealing material 15.

Fig. 12 is a schematic cross-sectional view showing another embodiment of a semiconductor device according to the invention. In the semiconductor device 210 shown in Fig. 12, the first-level semiconductor element 12a is bonded to the semiconductor element-mounting supporting member 13 on which terminals 16 have been formed, via a film-like adhesive 1 of the invention, and the second-level semiconductor element 12b is bonded on the first-level semiconductor element 12a also via a film-like adhesive 1 of the invention. The connecting terminals (not shown) of the first-level semiconductor element 12a and second-level semiconductor element 12b are electrically connected with external connecting terminals via wires 14, and are sealed with a sealing material. Thus, the film-like adhesive of the invention may be suitably used in a semiconductor device having a construction with a plurality of layered semiconductor elements.

The semiconductor devices (semiconductor packages) shown in Fig. 11 and Fig. 12 can be obtained, for example, by dicing the semiconductor wafer 20b shown in Fig. 9 along the dotted lines D, thermocompression bonding the diced film-like adhesive-attached semiconductor element onto the semiconductor element-mounting supporting member 13 to bond them, and then passing it through a wire bonding step, and if necessary also a sealing step with a sealing material. The heating temperature for thermocompression bonding is normally 20-250°C, the load is normally 0.01-20 kgf and the heating time is normally 0.1-300 seconds.

## Examples

The present invention will now be explained in greater detail based on examples and comparative examples, with the understanding that the invention is in no way limited to the examples.

(Synthesis of polyimide PI-1)

In a flask equipped with a stirrer, thermometer, condenser tube and nitrogen substitution device there were charged 1.89 g of 3,5-diaminobenzoic acid (molecular weight: 152.2, hereunder referred to as "DABA"), 15.21 g of aliphatic etherdiamine ("D-400", trade name of BASF, molecular weight: 452.4), 0.39 g of 1,1,3,3-tetramethyl-1,3-bis(4-aminophenyl)disiloxane ("LP-7100", trade name of Shin-Etsu Chemical Co., Ltd., molecular weight: 248.5) and 116 g of N-methyl-2-pyrrolidinone (hereunder referred to as "NMP").

Next, 16.88 g of 4,4'-oxydiphthalic dianhydride (molecular weight: 326.3, hereunder referred to as "ODPA") was added to the flask in small portions at a time while cooling the flask in an ice bath. Upon completion of the addition, the mixture was further stirred at room temperature for 5 hours.

A moisture receptor-equipped reflux condenser was then mounted on the flask, 70 g of xylene was added, the temperature was increased to 180°C while blowing in nitrogen gas to maintain the temperature for 5 hours, and the xylene was azeotropically removed with the water. The obtained solution was cooled to room temperature and then poured into distilled water for reprecipitation.

Next, the obtained precipitate was dried with a vacuum dryer to obtain a polyimide resin (hereunder referred to as "polyimide PI-1"). GPC measurement of the obtained polyimide resin resulted in Mw = 33,000 based on polystyrene. The Tg of the obtained polyimide resin was 55°C.

(Synthesis of polyimide PI-2)

In a flask equipped with a stirrer, thermometer and nitrogen substitution device there were charged 2.16 g of 5,5'-methylene-bis(anthranilic acid) (molecular weight: 286.3, hereunder referred to as "MBAA"), 15.13 g of aliphatic etherdiamine ("D-400"), 1.63 g of 1,1,3,3-tetramethyl-1,3-bis(4-aminophenyl)disiloxane ("LP-7100") and 115 g of NMP.

Next, 16.51 g of ODPA was added to the flask in small portions at a time while cooling the flask in an ice bath. Upon completion of the addition, the mixture was further stirred at room temperature for 5 hours.

A moisture receptor-equipped reflux condenser was then mounted on the flask, 81 g of xylene was added, the temperature was increased to 180°C while blowing in nitrogen gas to maintain the temperature for 5 hours, and the

xylene was azeotropically removed with the water.

The obtained solution was cooled to room temperature and then poured into distilled water for reprecipitation, to obtain a polyimide resin (hereunder referred to as "polyimide PI-2"). GPC measurement of the obtained polyimide resin resulted in Mw = 30,000 based on polystyrene. The Tg of the obtained polyimide resin was 31 °C.

(Synthesis of polyimide PI-3)

In a flask equipped with a stirrer, thermometer and nitrogen substitution device there were charged 20.5 g of 2,2-bis[4-(4-aminophenoxy)phenyl]propane (molecular weight: 410.5, hereinafter referred to as "BAPP") and 101 g of NMP

Next, 20.5 g of 1,2-(ethylene)bis(trimellitate anhydride) (molecular weight: 410.3, hereunder referred to as "EBTA") was added to the flask in small portions at a time while cooling the flask in an ice bath. Upon completion of the addition, the mixture was further stirred at room temperature for 5 hours.

A moisture receptor-equipped reflux condenser was then mounted on the flask, 67 g of xylene was added, the temperature was increased to 180°C while blowing in nitrogen gas to maintain the temperature for 5 hours, and the xylene was azeotropically removed with the water.

The obtained solution was cooled to room temperature and then poured into distilled water for reprecipitation, to obtain a polyimide resin (hereunder referred to as "polyimide PI-3"). GPC measurement of the obtained polyimide resin resulted in Mw = 98,000 based on polystyrene. The Tg of the obtained polyimide resin was 180°C.

(Examples 1 and 2 and Comparative Examples 1-4)

The polyimides PI-1 to -3 were used for mixing of the components in the compositional ratio listed in Table 1 (units: parts by mass), to prepare photosensitive adhesive compositions (adhesive layer-forming varnishes).

[Table 1]

| | | Examples | | | Comp. Ex. | | |
|---|---|---|---|---|---|---|---|
| | | 1 | 2 | 3 | 1 | 2 | 3 |
| Polyimide | PI-1 | - | 100 | - | - | 100 | - |
| | PI-2 | 100 | - | 100 | - | - | 100 |
| | PI-3 | - | - | - | 100 | - | - |
| Radiation-polymerizable compound | BPE-100 | 40 | 40 | 40 | - | - | 20 |
| | M-313 | 30 | - | - | - | - | - |
| | SB-220 | - | 20 | - | - | - | - |
| | M-140 | - | - | - | - | - | 40 |
| | EB-3708 | - | - | 40 | - | - | - |
| | EB-4858 | - | - | - | - | 80 | - |
| Epoxy resin YDF-8170 | YDF-817 | 5 | 5 | 5 | 5 | 5 | 5 |
| Curing agent | BEO-60E | 10 | 10 | 10 | 10 | 10 | 10 |
| | TrisP-PA | 5 | 5 | 5 | 5 | 5 | 5 |
| Filler | R-972 | 5 | 5 | 5 | 5 | 5 | 5 |
| Photoinitiator | I-651 | 3 | 3 | 3 | - | 3 | 3 |
| Coating solvent | NMP | 211 | 201 | 210 | 208 | 210 | 210 |

The symbols for the components in Table 1 have the following meanings.

BPE-100: Ethoxylated bisphenol A dimethacrylate by Shin-Nakamura Chemical Co., Ltd. (5% weight reduction temperature: 330°C)

M-313: Isocyanuric acid/EO-modified di- and triacrylate by Toagosei Co., Ltd. (5% weight reduction temperature: >400°C)

EB-220: Hexafunctional urethane acrylate by Daicel-Cytec Co., Ltd. (5% weight reduction temperature: 300°C)

M-140: N-Acryloyloxyethylhexahydrophthalimide by Toagosei Co., Ltd. (5% weight reduction temperature: 150°C)
EB-3708: Bifunctional epoxy acrylate by Daicel-Cytec Co., Ltd. (5% weight reduction temperature: 310°C)
EB-4858: Bifunctional urethane acrylate by Daicel-Cytec Co., Ltd. (5% weight reduction temperature: 160°C)

YDF-8170: Bisphenol F-type epoxy resin by Tohto Kasei Co., Ltd.
BEO-60E: Bisphenol A bis(triethyleneglycolglycidyl ether)ether by New Japan Chemical Co., Ltd.
TrisP-PA: Trisphenol compound ($\alpha$,$\alpha$,$\alpha$'-tris(4-hydroxyphenyl)-1-ethyl-4-isopropylbenzene) by Honshu Chemical Industry Co., Ltd.

R972: Hydrophobic fumed silica (mean particle size: approximately 16 nm) by Nippon Aerosil Co., Ltd.
1-651: 2,2-Dimethoxy-1,2-diphenylethan-1-one by Ciba Specialty Chemicals Co., Ltd.
NMP: N-methyl-2-pyrrolidinone by Kanto Kagaku Co., Ltd.

Each of the obtained varnishes was coated onto a base (release agent-treated PET film) to a post-drying thickness of 50 $\mu$m, and then heated in an oven at 80°C for 30 minutes and then at 120°C for 30 minutes to obtain adhesive sheets having adhesive layers formed on bases.

<Evaluation of low-temperature attachment property>

Each of the adhesive sheets obtained in Examples 1 and 2 and Comparative Examples 1-4 was laminated onto the back side of a silicon wafer (6-inch diameter, 400 $\mu$m thickness) that had been placed on a support stage (onto the side opposite the support stage side), by orienting the adhesive layer to the silicon wafer side and pressing with a roll (temperature: 100°C, linear pressure: 4 kgf/cm, feed rate: 0.5 m/min). Next, the base (PET film) was peeled off and an 80 $\mu$m-thick, 10 mm-wide, 40 mm-long polyimide film (UPILEX, trade name of Ube Industries, Ltd.) was pressed onto the adhesive layer with a roll under the same conditions described above for lamination.

Each sample prepared in this manner was subjected to a 90° peel test at room temperature using a rheometer (STROGRAPH E-S, trade name of Toyo Seiki Laboratories), for measurement of the adhesive layer-UPILEX peel strength. Samples with a peel strength of 2 N/cm or greater were evaluated as A, and samples with less than 2 N/cm were evaluated as B, based on the measurement results. The results are shown in Table 2.

<Evaluation of pattern formability>

Each of the adhesive sheets of Examples 1 and 2 and Comparative Examples 2-4 was laminated onto a silicon wafer (6-inch diameter, 400 $\mu$m thickness) at a temperature of 100°C while the adhesive sheet of Comparative Example 1 was laminated at a temperature of 300°C, by orienting the adhesive layer to the silicon wafer side and pressing with a roll (linear pressure: 4 kgf/cm, feed rate: 0.5 m/min). Next, a negative pattern mask ("No.G-2", trade name of Hitachi Chemical Co., Ltd.) was placed on the base (PET film) and exposed at 500 mJ/cm$^2$ with a high precision parallel exposure apparatus ("EXM-1172-B-$\infty$, trade name of Ore Manufacturing Co., Ltd.), and allowed to stand for approximately 30 seconds on a hot plate at 80°C.

The base (PET film) was then removed, and a conveyor developing machine (Yako Co., Ltd.) was used for spray development with a 2.38 mass% solution of tetramethylammonium hydride (TMAH) as the developing solution, a temperature of 28°C and a spray pressure of 0.18 MPa, after which it was washed with purified water at a temperature of 23°C and a spray pressure of 0.02 MPa. After development, it was visually confirmed whether a pattern with line width/space width = 200 $\mu$m/400 $\mu$m had been formed, and an evaluation of A was assigned for pattern formation while B was assigned for no pattern formation. The results are shown in Table 2.

<Measurement of 250°C peel strength (evaluation of adhesion at high temperature)>

A silicon wafer (6-inch diameter, 400 $\mu$m thickness) was half-cut to a size of 5 mm $\times$ 5 mm and a depth of 180 $\mu$m. Each of the adhesive sheets of Examples 1 and 2 and Comparative Examples 2-4 was then laminated onto the half-cut silicon wafer at a temperature of 100°C while the adhesive sheet of Comparative Example 1 was laminated at a temperature of 300°C, by orienting the adhesive layer to the silicon wafer side and pressing with a roll (linear pressure: 4 kgf/cm, feed rate: 0.5 m/min). The obtained sample was exposed at 500 mJ/cm$^2$ with a high precision parallel exposure apparatus ("EXM-1172-B-$\infty$, trade name of Orc Manufacturing Co., Ltd.), and allowed to stand for approximately 30 seconds on a hot plate at 80°C.

The base (PET film) was then removed and the sample was individuated to 5 mm $\times$ 5 mm. The individuated adhesive layer-attached silicon wafer was placed on a glass panel (10 mm $\times$ 10 mm $\times$ 0.55 mm) with the adhesive layer on the glass panel side, and contact bonded for 10 seconds at 120°C while pressing at 2 kgf. The obtained test piece was heat cured in an oven at 120°C for 3 hours. Next, the test piece was heated on a heating plate at 260°C for 10 seconds, and the peel strength tester shown in Fig. 13 was used to measure the peel strength of the silicon wafer at 260°C with a measuring speed of 0.5 mm/sec, with the value being recorded as the 260°C peel strength. The results

are shown in Table 2.

In the peel strength tester 300 shown in Fig. 13, a handle 32 with variable angle around a fulcrum 33 is provided at the end of a rod mounted on a push-pull gauge 31. Measurement of the 260°C peel strength was accomplished by placing the test piece, comprising a silicon wafer 34 with a protrusion and a glass panel 35 bonded via an adhesive layer 1, on a heating plate 36 at 260°C and, with the handle 32 engaged with the protrusion of the silicon wafer 34, using the push-pull gauge 31 to measure the peel stress when the handle 32 was moved at 0.5 mm/sec.

<Measurement of 5% weight reduction temperature of radiation-polymerizable compounds>

The radiation-polymerizable compounds were combined in prescribed weight ratios, and a differential thermal/thermogravimetric simultaneous measurement apparatus ("TG/DTA6300", trade name of SII NanoTechnology Inc.) was used for measurement of the 5% weight reduction temperature under a nitrogen flow (400 ml/min). The results are shown in Table 2.

<Measurement of 5% weight reduction temperature of adhesive layer>

Each of the adhesive sheets of Examples 1 and 2 and Comparative Examples 2-4 was laminated onto a silicon wafer (6-inch diameter, 400 μm thickness) at a temperature of 100°C while the adhesive sheet of Comparative Example 1 was laminated at a temperature of 300°C, by orienting the adhesive layer to the silicon wafer side and pressing with a roll (linear pressure: 4 kgf/cm, feed rate: 0.5 m/min).

The obtained sample was exposed at 500 mJ/$cm^2$ with a high precision parallel exposure apparatus ("EXM-1172-B-∞, trade name of Orc Manufacturing Co., Ltd.), and allowed to stand for approximately 30 seconds on a hot plate at 80°C. The base (PET film) was then removed, and after heat curing in an oven under conditions of 120°C, 3 hours, the adhesive layer on the silicon wafer was shaved off and a differential thermal/thermogravimetric simultaneous measurement apparatus ("TG/DTA6300", trade name of SII NanoTechnology Inc.) was used to measure the 5% weight reduction temperature under a nitrogen flow (400 ml/min). The results are shown in Table 2.

[Table 2]

| | Example | | | Comp. Ex. | | |
|---|---|---|---|---|---|---|
| | 1 | 2 | 3 | 1 | 2 | 3 |
| Low-temperature attachment property | A | A | A | B | A | A |
| Pattern formability | A | A | A | B | A | A |
| 260°C Peel strength (MPa) | 0.2 | 0.2 | 0.2 | 0.7 | 0.01 | 0.02 |
| 5% Weight reduction temperature of all of all of the radiation-polymerizable compounds (°C) | 360 | 315 | 320 | - | 160 | 150 |
| 5% Weight reduction temperature of adhesive layer (°C) | 360 | 320 | 320 | 332 | 250 | 220 |

As clearly seen by the results in Table 2, the adhesive sheets of Examples 1-3 had more excellent low-temperature attachment properties and pattern formability than those of Comparative Examples 1-3, as well as more adequate 260°C peel strengths and higher 5% weight reduction temperatures of the adhesive layers.

## Industrial Applicability

As explained above, it is possible according to the invention to provide a photosensitive adhesive composition having excellent pattern formability with alkali developing solutions, a satisfactory re-adhesion property after light exposure, and an excellent low-temperature attachment property when formed into a film. It is also possible according to the invention to provide a film-like adhesive having excellent pattern formability with alkali developing solutions, a satisfactory re-adhesion property after light exposure and an excellent low-temperature attachment property, and a method for forming an adhesive pattern. It is further possible according to the invention to provide an adhesive sheet, a semiconductor wafer with an adhesive layer, a semiconductor device and a method for manufacturing a semiconductor device, which can contribute to increased efficiency for semiconductor device assembly processes.

## Claims

1. A photosensitive adhesive composition comprising

    (A) an alkali-soluble polymer,
    (B) a thermosetting resin,
    (C) one or more radiation-polymerizable compounds and
    (D) a photoinitiator,

    wherein the 5% weight reduction temperature of the mixture of all of the radiation-polymerizable compounds in the composition is 200°C or higher.

2. A photosensitive adhesive composition according to claim 1, wherein the (C) radiation-polymerizable compound comprises a compound with a urethane and/or isocyanurate group.

3. A photosensitive adhesive composition according to claim 1 or 2, wherein the (C) radiation-polymerizable compound comprises an acrylate compound and/or methacrylate compound.

4. A photosensitive adhesive composition according to any one of claims 1 to 3, wherein the (C) radiation-polymerizable compound comprises a trifunctional or greater acrylate compound.

5. A photosensitive adhesive composition according to any one of claims 1 to 4, wherein the (C) radiation-polymerizable compound comprises an ethylene oxide isocyanurate-modified di- or triacrylate represented by the following general formula (I).

[Chemical Formula 1]

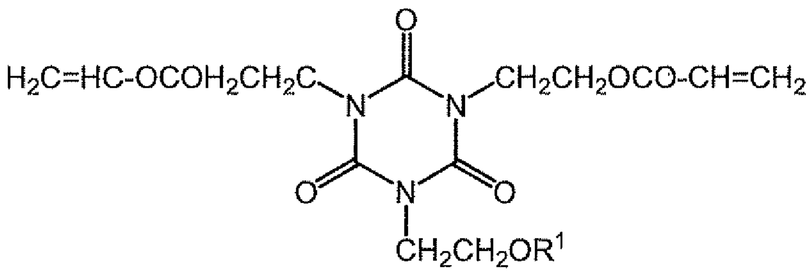

(I)

[In formula (I), $R^1$ represents hydrogen or $-COCH=CH_2$.]

6. A photosensitive adhesive composition according to any one of claims 1 to 5, wherein the (B) thermosetting resin comprises an epoxy resin.

7. A photosensitive adhesive composition according to any one of claims 1 to 6, wherein the glass transition temperature of the (A) alkali-soluble polymer is no higher than 150°C.

8. A photosensitive adhesive composition according to any one of claims 1 to 7, wherein the (A) alkali-soluble polymer is a resin with a carboxyl and/or hydroxyl group.

9. A photosensitive adhesive composition according to any one of claims 1 to 8, wherein the (A) alkali-soluble polymer is a polyimide resin.

10. A photosensitive adhesive composition according to claim 9, wherein the polyimide resin is a polyimide resin obtained by reaction between a tetracarboxylic dianhydride and a diamine with a carboxyl and/or hydroxyl group in the molecule.

**11.** A photosensitive adhesive composition according to claim 9 or 10, wherein the polyimide resin is a polyimide resin obtained by reacting a tetracarboxylic dianhydride with an aromatic diamine represented by the following formula (II) and/or an aromatic diamine represented by the following formula (III).

[Chemical Formula 2]

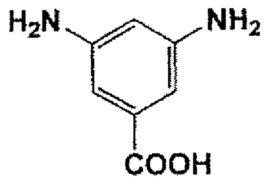

(II)

[Chemical Formula 3]

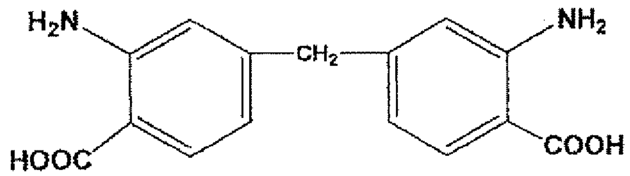

(III)

**12.** A film-like adhesive obtained by forming a photosensitive adhesive composition according to any one of claims 1 to 11 into a film shape.

**13.** An adhesive sheet comprising a base and an adhesive layer composed of a photosensitive adhesive composition according to any one of claims 1 to 11 formed on one side of the base.

**14.** An adhesive sheet having a structure obtained by laminating a film-like adhesive according to claim 12 with a dicing sheet.

**15.** A method for forming an adhesive pattern, wherein an adhesive layer composed of a photosensitive adhesive composition according to any one of claims 1 to 11 is formed on an adherend, the adhesive layer is exposed to light through a photomask, and the exposed adhesive layer is developed with an alkali developing solution.

**16.** A semiconductor wafer with an adhesive layer, that comprises a semiconductor wafer and an adhesive layer composed of a photosensitive adhesive composition according to any one of claims 1 to 11 formed on one side of the semiconductor wafer.

**17.** A semiconductor device having a structure wherein a semiconductor element and a semiconductor element-mounting supporting member are bonded using a photosensitive adhesive composition according to any one of claims 1 to 11.

**18.** A method for manufacturing a semiconductor device, which comprises a step of bonding a semiconductor element and a semiconductor element-mounting supporting member using a photosensitive adhesive composition according to any one of claims 1 to 11.

Fig.1

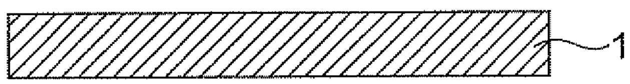

Fig.2

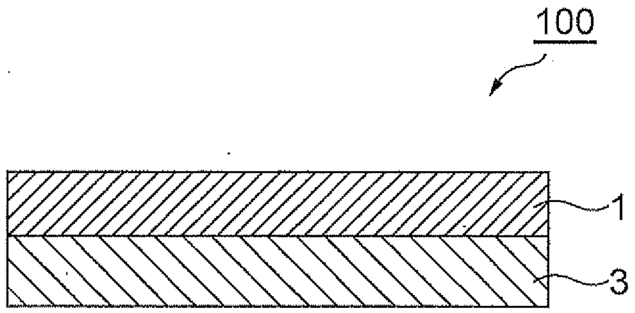

*Fig.3*

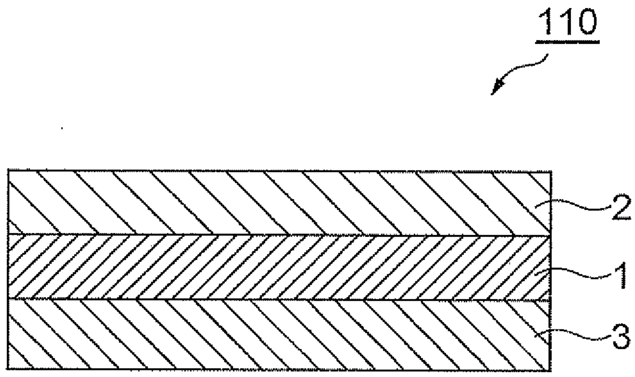

*Fig.4*

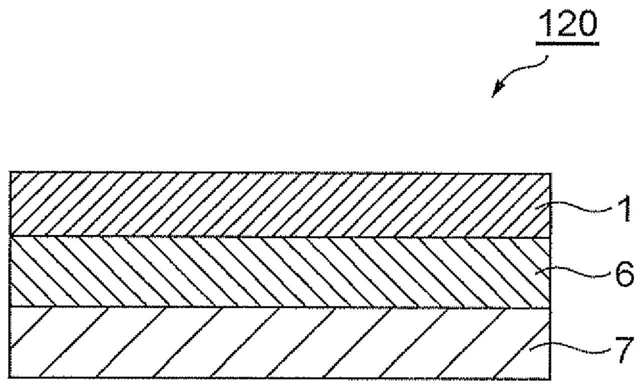

Fig.5

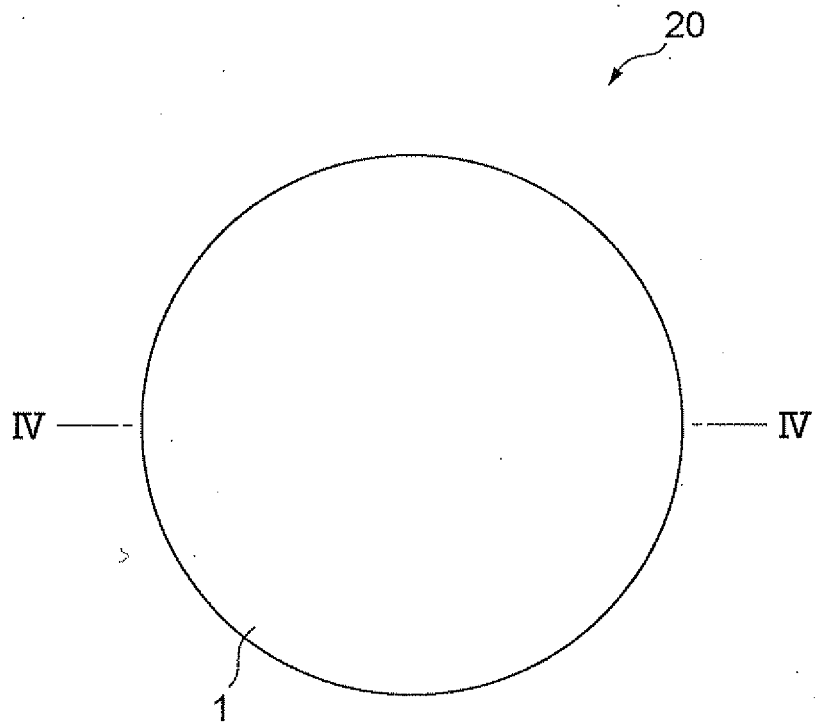

Fig.6

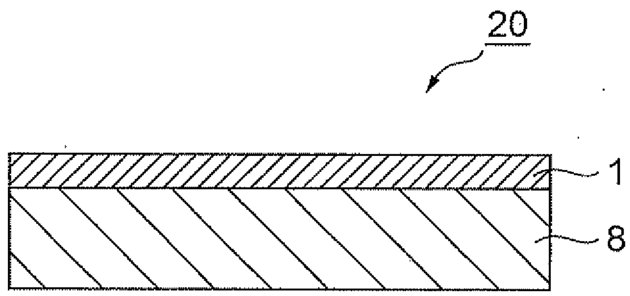

*Fig.7*

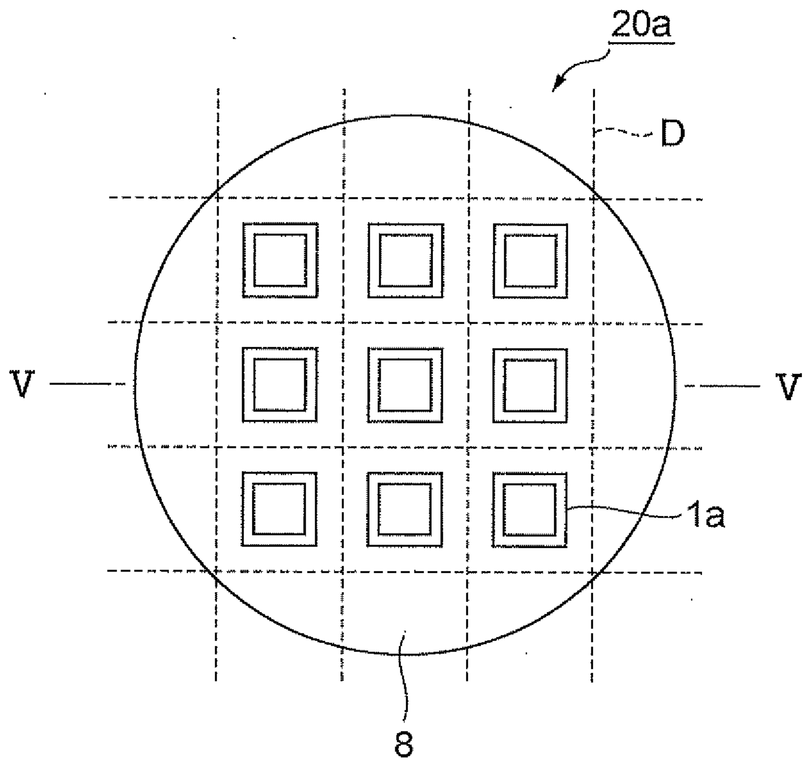

*Fig.8*

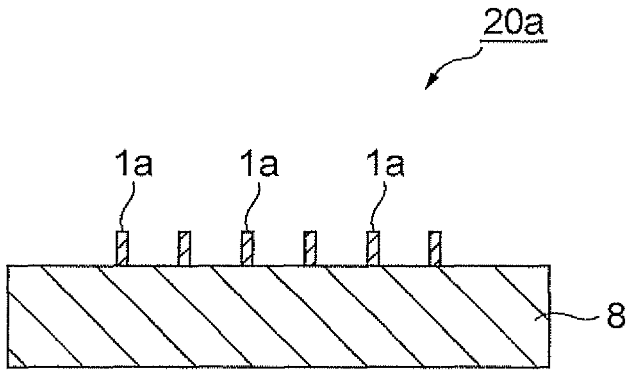

*Fig.9*

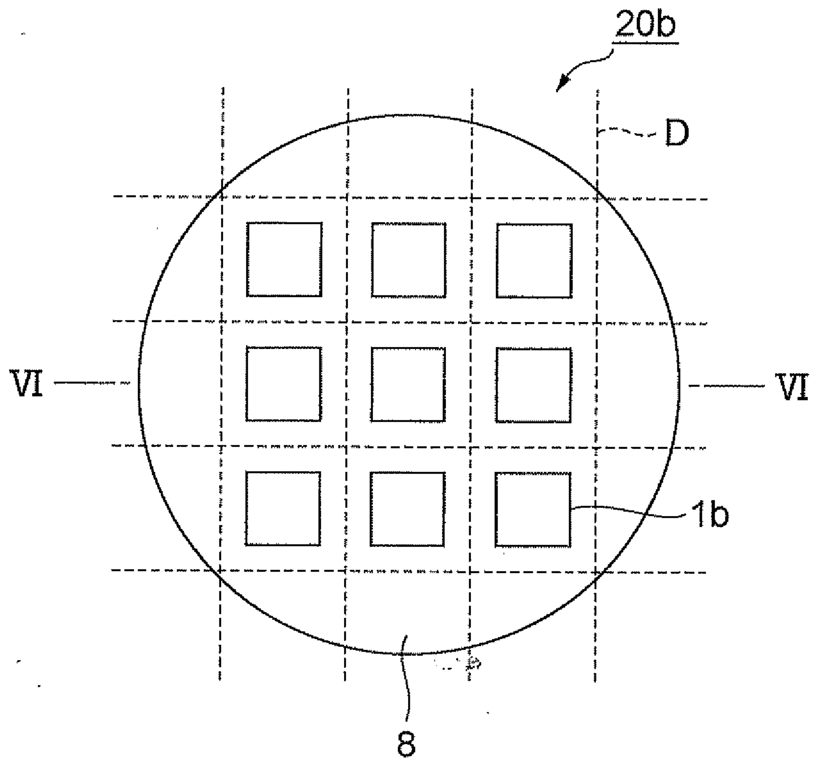

Fig.10

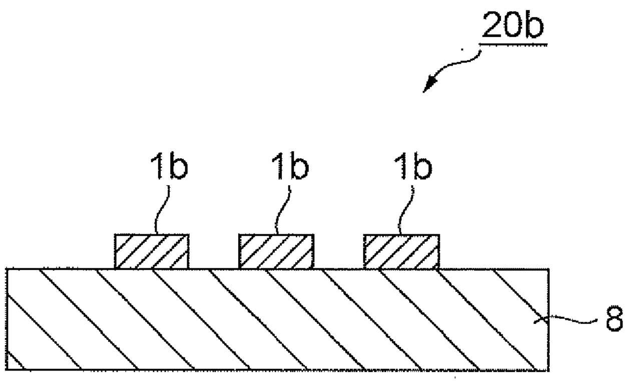

**Fig.11**

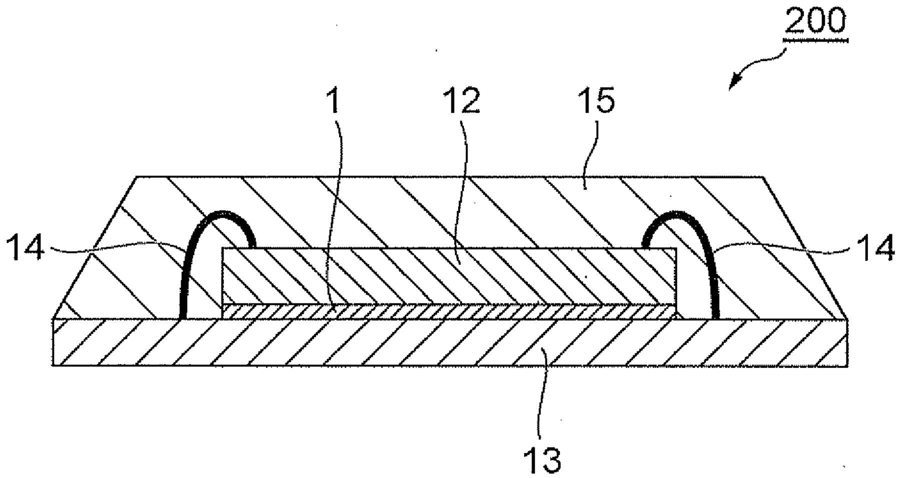

*Fig.12*

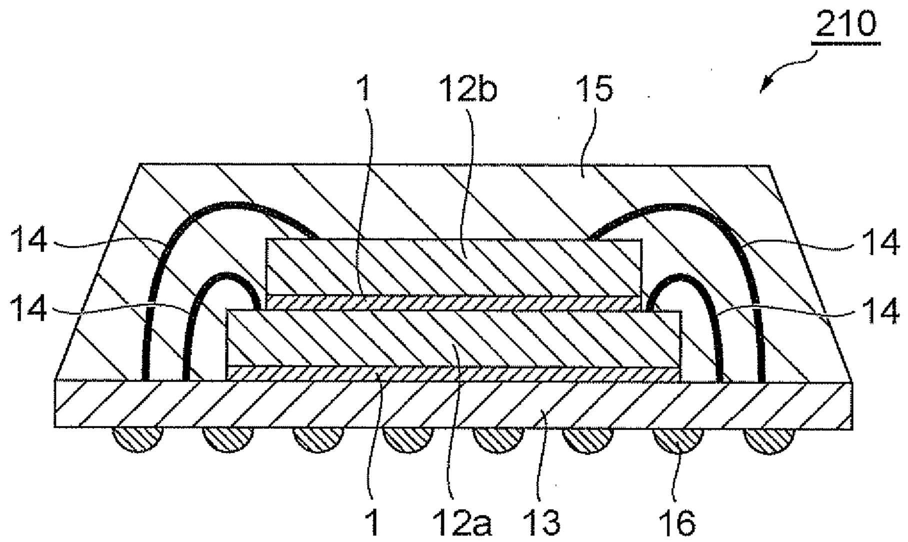

Fig.13

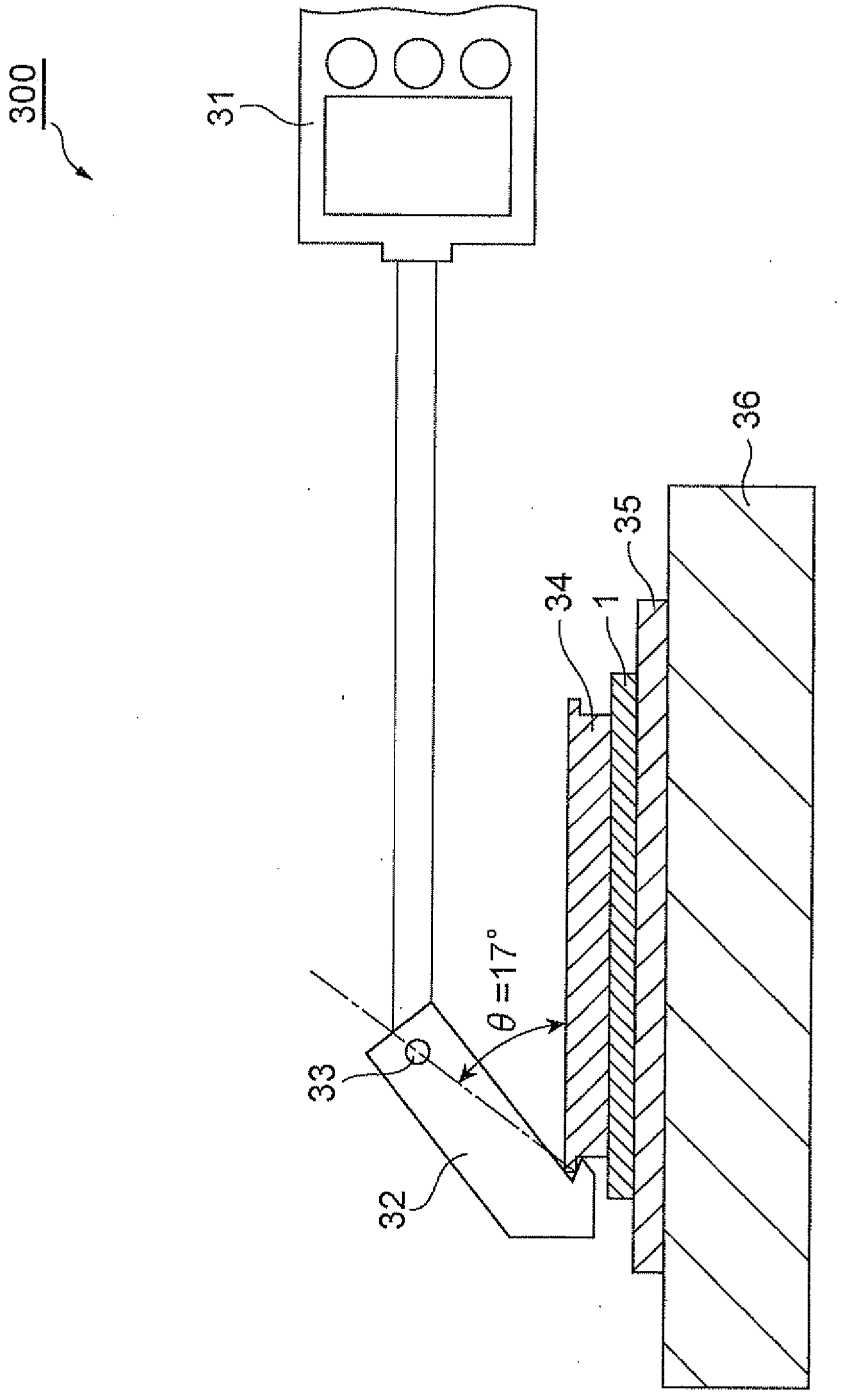

**INTERNATIONAL SEARCH REPORT**

International application No. PCT/JP2008/058246

A. CLASSIFICATION OF SUBJECT MATTER
*G03F7/027*(2006.01)i, *C08G73/10*(2006.01)i, *C09J4/02*(2006.01)i, *C09J7/02*(2006.01)i, *C09J163/00*(2006.01)i, *C09J179/08*(2006.01)i, *G03F7/004*(2006.01)i, *G03F7/037*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/027, C08G73/10, C09J4/02, C09J7/02, C09J163/00, C09J179/08, G03F7/004, G03F7/037, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2002-003715 A (Kaneka Corp.), 09 January, 2002 (09.01.02), Claims 1 to 11; Par. Nos. [0001] to [0007], [0102] to [0125] (Family: none) | 1-5,12-13, 15-18 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 July, 2008 (07.07.08) | 15 July, 2008 (15.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/058246

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The claims contain the following five groups of inventions. The technical feature common to the following groups a-d is considered to be the photosensitive resin composition of claim 1.

a. claims 1-5, 12-13, 15-18

b. claim 6 c. claims 7-11 d. claim 14

The international search, however, has revealed that the photosensitive resin composition of claim 1 is not novel since it is disclosed in the document cited in this international search report. Consequently, the common technical feature is not a special technical feature, since the photosensitive resin composition of claim 1 (continued to extra sheet)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-5, 12-13, 15-18

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

**INTERNATIONAL SEARCH REPORT**

International application No.
PCT/JP2008/058246

Continuation of Box No.III of continuation of first sheet(2)

makes no contribution over the prior art. Therefore, the groups a-d do not satisfy the requirement of unity of invention.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000290501 A
- JP 2001329233 A
- JP 11024257 A


### Non-patent literature cited in the description


- *Journal of Photopolymer Science and Technology,* 1999, vol. 12, 313-314
- *Chemistry of Materials,* 1999, vol. 11, 170-176
- *Journal of American Chemical Society,* 1996, vol. 118, 12925
- *Polymer Journal,* 1996, vol. 28, 795